# EUROPÄISCHE PATENTSCHRIFT

(11) **EP 3 610 517 B1**
(45) Veröffentlichungstag und Bekanntmachung des Hinweises auf die Patenterteilung: **27.09.2023**
(21) Anmeldenummer: 18718146.6
(22) Anmeldetag: 13.04.2018
(51) Int. Cl.: H01L 31/055, G02B 1/04

(54) **VORRICHTUNG ZUM LEITEN VON LICHT UND HERSTELLUNGSVERFAHREN**
DEVICE FOR GUIDING LIGHT AND PRODUCTION METHOD
DISPOSITIF DE GUIDAGE DE LUMIÈRE ET PROCÉDÉ DE FABRICATION

(30) Priorität: 13.04.2017 DE 102017206421; 05.05.2017 DE 102017207657; 13.02.2018 DE 102018202221
(43) Veröffentlichungstag der Anmeldung: 19.02.2020
(73) Patentinhaber: Technische Universität Braunschweig, 38106 Braunschweig (DE); Walla, Peter Jomo, 38106 Braunschweig (DE); Pieper, Alex, 38106 Braunschweig (DE)
(72) Erfinder: WALLA, Peter Jomo, 38106 Braunschweig (DE); PIEPER, Alex, 38106 Braunschweig (DE)
(74) Vertreter: Taruttis, Stefan Georg
(86) Internationale Anmeldenummer: PCT/EP2018/059597
(87) Internationale Veröffentlichungsnummer: WO 2018/189394

(56) Entgegenhaltungen:
- WO-A1-2010/124279
- WO-A1-2014/142650
- DE-A1-102013 113 533
- US-A1- 2010 139 749
- US-A1- 2014 318 601

## Beschreibung

Die vorliegende Erfindung betrifft eine Vorrichtung zum Leiten von Licht, die sich insbesondere zum Sammeln von diffusem Licht eignet, und ein Herstellungsverfahren für die Vorrichtung. Die Vorrichtung ermöglicht ein Verfahren zum Sammeln von Licht, das diffuses Licht sein kann, insbesondere Sonnenlicht, und Emittieren des Lichts bevorzugt parallel zu einer Ebene. Entsprechend betrifft die Erfindung auch ein Verfahren zum Konzentrieren von Licht, insbesondere von diffusem Sonnenlicht, wobei das emittierte Licht in parallelen Ebenen abgestrahlt wird. Das emittierte Licht wird bevorzugt auf ein photovoltaisches Element gerichtet. Das photovoltaische Element kann in den parallelen Ebenen angeordnet sein, in denen Licht emittiert wird, oder in einer Ebene, in die das emittierte Licht mittels optischer Elemente, z.B. durch Spiegel, totalreflektierende Grenzschichten, oder Lichtleiter, umgelenkt wird.

### Stand der Technik

Die DE 10 2013 113 533 A1 beschreibt eine Folie, in der Farbstoffmoleküle mit anisotroper Molekülstruktur enthalten sind, die durch Recken der Folie anisotrop ausgerichtet sind. Dabei kann auch ein weiterer Farbstoff enthalten sein, dessen Moleküle wie die des ersten Farbstoffs parallel zueinander ausgerichtet sind.

Die US 2014/0318601 A1 zeigt einen Träger, in dem verschiedene fluoreszierende Farbstoffe enthalten sind, beispielsweise können vier verschiedene fluoreszierende Farbstoffe in einem durchsichtigen Träger enthalten sein, bei denen sich das Emissionsspektrum eines Farbstoffs mit dem Absorptionsspektrum eines anderen Farbstoffs überschneidet.

Hyon et al., Polymer Bulletin 1989, 22, 119 beschreiben die Herstellung transparenter PVA-Folien.

Die US 2011/0253197 A1 beschreibt Lichtsammelplatten, bei denen auf einer Glasplatte eine polymerisierte Schicht liegt, in der zwei Farbstoffe enthalten sind, von denen einer einfallendes Licht absorbiert, aufgenommene Energie auf den anderen Farbstoff überträgt und dieser eingerichtet ist, die Energie in einer Richtung und mit Rotverschiebung abzugeben.

### Aufgabe der Erfindung

Die Aufgabe der Erfindung liegt darin, eine alternative Vorrichtung und ein Verfahren zum Sammeln und Leiten von Licht bereitzustellen, insbesondere von diffusem Licht.

### Beschreibung der Erfindung

Die Erfindung löst die Aufgabe mit den Merkmalen der Ansprüche und insbesondere mittels einer Vorrichtung zum Leiten von Licht, insbesondere zum Sammeln und Leiten von Licht, z.B. parallel zu einer Ebene, in der ein optisches Element, bevorzugt ein photovoltaisches Element angeordnet ist. Dabei sind erfindungsgemäß ein erster Farbstoff und ein zweiter Farbstoff in einem transparenten Träger verteilt, wobei der zweite Farbstoff vom ersten Farbstoff absorbierte Lichtenergie aufnimmt und bevorzugt parallel zu einer gemeinsamen Ebene emittiert, weil die Moleküle des zweiten Farbstoffs so in dem Träger ausgerichtet sind, dass ihre Übergangsdipolmomente parallel zueinander liegen. Dabei weisen die Moleküle des zweiten Farbstoffs z.B. dann dieselbe räumliche Ausrichtung auf bzw. ihre Übergangsdipolmomente liegen parallel zueinander, wenn sie in einem Winkel von maximal 30°, bevorzugt maximal 20°, bevorzugter maximal 10° oder maximal 5°, noch bevorzugter maximal 2° zueinander angeordnet sind. Die Übertragung der Lichtenergie auf den zweiten Farbstoff kann entweder direkt durch Energietransfer, wie z.B. einem Förster-Energietransfer, stattfinden oder durch Absorption des vom ersten Farbstoff emittierten Lichtes oder auch durch einen anderen Übertragungsmechanismus. Bei Übertragung der Energie vom ersten Farbstoff auf den zweiten Farbstoff ohne Emission, z.B. durch Förster-Energietransfer, kann der Absorptionswellenlängenbereich des zweiten Farbstoffs in einem Bereich liegen, der sich nicht mit dem Emissionswellenlängenbereich des ersten Farbstoffs überdeckt.

Die Ausrichtung des zweiten Farbstoffs so, dass dessen Übergangsdipolmomente parallel zueinander sind, erfolgt durch Ausrichten der Moleküle des zweiten Farbstoffs parallel zueinander. Als Folge dieser zueinander parallelen Anordnung der Moleküle des zweiten Farbstoffs in dem Träger sind auch deren Übergangsdipolmomente parallel zueinander angeordnet, z.B. parallel oder in einem Winkel von bis zu 90° zur Ausrichtung der Moleküle.

Da Licht senkrecht zum Übergangsdipolmoment emittiert wird, führt die parallele Ausrichtung der Moleküle des zweiten Farbstoffs dazu, dass emittiertes Licht senkrecht zu den Übergangsdipolmomenten und damit in einer bzw. in zueinander parallelen Ebenen, bzw. parallel zu einer gemeinsamen Graden, abgestrahlt wird.

Dabei weist der erste Farbstoff einen ersten Absorptionswellenlängenbereich und einen ersten Emissionswellenlängenbereich auf und der zweite Farbstoff weist einen zweiten Absorptionswellenbereich und einen zweiten Emissionswellenlängenbereich auf, wobei sich optional der erste Emissionswellenlängenbereich und der zweite Absorptionswellenlängenbereich zumindest anteilig überdecken. Daher kann der zweite Farbstoff das vom ersten Farbstoff im ersten Wellenlängenbereich emittierte Licht entweder einfach absorbieren oder dessen Energie besonders gut durch einen Energietransfermechanismus, wie z.B. einem Förster-Energietransfer, empfangen. Der erste Absorptionswellenlängenbereich ist optional bei kürzeren Wellenlängen als der zweite Absorptionswellenlängenbereich.

In einem Träger kann zumindest ein dritter Farbstoff verteilt sein, der jeweils einen anderen Absorptionswellenlängenbereich, auch dritter Absorptionswellenlängenbereich genannt, aufweist, als der erste Absorptionswellenlängenbereich, so dass der zumindest eine dritte oder ein vierter Farbstoff Licht zumindest einer anderen Wellenlänge absorbiert als der erste Farbstoff und dennoch der zumindest eine dritte bzw. vierte Farbstoff Licht in jeweils zumindest einem dritten Emissionswellenlängenbereich emittiert, der vom zweiten Farbstoff absorbiert wird.

Der dritte Absorptionswellenlängenbereich und der erste Absorptionswellenlängenbereich überdecken sich maximal zu 20%, bevorzugt zu maximal 10% oder überdecken sich nicht. Der dritte Farbstoff kann in demselben Träger wie der erste Farbstoff oder in einem anderen Träger enthalten sein. Die Vorrichtung kann in demselben Träger oder einem weiteren Träger einen vierten und/oder weiteren Farbstoff aufweisen, der einen anderen Absorptionswellenlängenbereich als der erste und als der dritte Farbstoff aufweisen, und in jedem Träger einen zweiten Farbstoff, der einen zweiten Absorptionswellenlängenbereich aufweist, der sich zumindest anteilig mit dem Emissionswellenlängenbereich des vierten und weiteren Farbstoffs überdeckt. Diese Ausführungsform hat den Vorteil, dass der erste und der zusätzliche, zumindest eine dritte Farbstoff und ggf. ein vierter Farbstoff jeweils verschiedene Wellenlängenbereiche des einfallenden Lichts absorbieren und auf einen zweiten Farbstoff übertragen, so dass die Ausbeute steigt.

Der zweite Farbstoff, der in dem Träger verteilt ist, in dem zumindest ein dritter Farbstoff oder in dem Träger, in dem ein vierter Farbstoff enthalten ist, kann derselbe zweite Farbstoff sein, wie derjenige, der in dem Träger verteilt ist, in dem der erste Farbstoff verteilt ist.

Alternativ kann der zweite Farbstoff, der in dem Träger verteilt ist, in dem zumindest ein dritter Farbstoff oder ein vierter Farbstoff enthalten ist, ein anderer zweiter Farbstoff sein als derjenige, der in dem Träger verteilt ist, in dem der erste Farbstoff verteilt ist. Ein solcher anderer zweiter Farbstoff kann einen anderen Absorptionswellenlängenbereich und/oder einen anderen Emissionswellenlängenbereich aufweisen.

Der erste Farbstoff und optional zumindest ein dritter bzw. vierter Farbstoff ist bevorzugt zufällig ausgerichtet oder ist zumindest zum Teil in jeweils einer gemeinsamen Orientierung ausgerichtet. Der erste Farbstoff und optional zumindest ein dritter bzw. vierter Farbstoff sammeln einfallendes Licht in ihrem jeweiligen Absorptionswellenlängenbereich und entsprechend ihrer Ausrichtung bzw. entsprechend der Ausrichtung ihrer Übergangsdipolmomente. In der zufälligen Ausrichtung des ersten Farbstoffs, und entsprechend in zufälliger Ausrichtung eines dritten und/oder vierten Farbstoffs, wird ein effektives Aufnehmen eingestrahlter Energie erlaubt, insbesondere von diffusem Licht. Der zweite Farbstoff nimmt Energie des ersten Farbstoffes auf, bzw. die Energie des dritten bzw. vierten Farbstoffs, und emittiert auf Grund seiner parallelen Ausrichtung parallel zu einer gemeinsamen Ebene bzw. Graden, so dass auch diffus auf die Vorrichtung eingestrahltes Licht durch den ersten und optional zumindest einen dritten bzw. vierten Farbstoff absorbiert wird, auf einen zweiten Farbstoff übertragen wird und vom zweiten Farbstoff in zueinander parallelen Ebenen, bzw. parallel zu einer gemeinsamen Graden, emittiert wird. In der Folge wird auf die Vorrichtung einfallendes Licht, das diffuses Sonnenlicht sein kann, durch den zweiten Farbstoff in zueinander parallelen Ebenen emittiert und dadurch gesammelt und konzentriert. Das vom zweiten Farbstoff emittierte Licht kann direkt oder mittels optischer Elemente, z.B. Spiegeln und/oder totalreflektierender Grenzflächen eines transparenten Festkörpers, auf ein energiewandelndes Element, das insbesondere ein photovoltaisches Element ist, gerichtet werden. Der dritte und vierte Farbstoff unterscheiden sich vom ersten Farbstoff im Absorptionswellenlängenbereich, haben jedoch dieselbe Funktion und Ausrichtung im Träger, wie der erste Farbstoff. Daher gilt die Beschreibung in Bezug auf den ersten Farbstoff mit Ausnahme der unterschiedlichen Absorptionswellenlängenbereiche auch für den dritten und vierten Farbstoff.

Generell oder optional sind der erste Farbstoff und der zweite Farbstoff in dem Träger zum Förster-Energietransfer eingerichtet, insbesondere in dem Träger in einem Abstand, in dem ein Förster-Energietransfer auftreten kann. Dabei absorbiert der erste Farbstoff eingestrahltes Licht und überträgt einen erheblichen Teil der Lichtenergie, insbesondere zumindest 50%, bevorzugt zumindest 80 oder 95%, direkt auf den zweiten Farbstoff. Daher kann der erste Farbstoff als Donor bezeichnet werden und der zweite Farbstoff als Akzeptor.

Der erste Farbstoff und der zweite Farbstoff sind bevorzugt in Konzentrationen in dem Träger enthalten, dass sie in einem mittleren Abstand von maximal 10 nm voneinander angeordnet sind, bevorzugt in einem Abstand von 1 bis 5 nm, bevorzugter von 1 bis 3 nm oder von 2 bis 3 nm. Bevorzugt ist der erste Farbstoff jeweils in einer molaren Konzentration von zumindest 3-fach, bevorzugter zumindest 5-fach, z.B. bis 50-fach oder bis 30-fach oder bis 20-fach der molaren Konzentration des zweiten Farbstoffs in dem Träger enthalten.

Die ersten Farbstoffe, insbesondere organische Farbstoffe, können Gewichtsverhältnisse von 1:50 bis 1 :200, z.B. 1:80 bis 1:150 in Bezug zum Gewichtsanteil des ersten Farbstoffs zum Trägermaterial haben. Dabei können die zweiten Farbstoffe eine 5-fach bis 20-fach geringere molare Konzentration in Bezug zur Konzentration des ersten Farbstoffes haben. Diese Gewichts- und Konzentrationsverhältnisse sind insbesondere bei Streckungen des Trägers um 200 bis 500 % in einer Dimension bevorzugt. Diese Verhältnisse wurden durch Intensitätsmessungen der Emission des zweiten Farbstoffs nach Anregung des ersten Farbstoffs bestimmt.

Bevorzugt ist der zweite Farbstoff durch Recken des Trägers in diesem ausgerichtet, wobei der in dem Träger enthaltene erste Farbstoff, und entsprechend ein dritter und/oder vierter Farbstoff, in zufälliger Ausrichtung oder Anordnung in dem Träger enthalten ist. Die zufällige Ausrichtung kann auch als zufällige Orientierung der Moleküle des ersten bzw. dritten und/oder vierten Farbstoffs bezeichnet werden, da diese generell bevorzugt keine gemeinsame Ausrichtung aufweisen, sondern vielmehr unorientiert bzw. zufällig angeordnet in dem Träger enthalten sind.

Die Farbstoffe können kovalent am Träger gebunden sein. Erfindungsgemäß bevorzugt sind die Farbstoffe ohne kovalente Bindung an den Träger in diesem enthalten.

Es hat sich gezeigt, dass das Recken, auch als Strecken bezeichnet, des Trägers mit den darin enthaltenen Farbstoffen dazu führt, dass im Wesentlichen nur der zweite Farbstoff ausgerichtet wird und der erste Farbstoff in zufälliger Ausrichtung in dem Träger enthalten ist. Dazu weist der zweite Farbstoff anisotrope Moleküle auf, z.B. Moleküle mit anisotroper Gestalt, Moleküle mit anisotropem Dipolmoment und/oder Moleküle, die eine anisotrope Struktur aufweisen, z.B. keine strukturelle Symmetrie haben, oder aus anisotropen Molekülen. Dazu weist der zweite Farbstoff z.B. ein Molekül einer anisotropen Gestalt auf, das eine gestreckte Molekülgestalt hat, z.B. ein Verhältnis von Länge zu Breite von zumindest 1,8:1 hat, z.B. bis 100:1, und/oder der zweite Farbstoff weist ein anisotropes Dipolmoment auf, das z.B. ein permanentes Dipolmoment von zumindest 1 Debye, z.B. bis 10 Debye ist, und/oder der zweite Farbstoff hat eine anisotrope Molekülstruktur, z.B. keine strukturelle Symmetrie, die sich den Symmetrieklassen n-zahliger Rotation Cₙ, Inversion i, Spiegelung σ, oder einer Drehspiegelachse Sₙ zuordnen lässt und die z.B. auch als chemische Anisotropie bezeichnet wird. Die anisotropen Moleküle, die den zweiten Farbstoff bilden und aus denen der zweite Farbstoff bevorzugt besteht, bilden eine Molekülform, die beim Recken des Trägers (1b) ausgerichtet wird.

Gegenwärtig wird die Ausrichtung des zweiten Farbstoffs durch das Recken eines diesen enthaltenden Trägers auf die Anisotropie seiner Farbstoffmoleküle zurückgeführt.

Der erste Farbstoff, entsprechend ein dritter und vierter Farbstoff, weist bevorzugt isotrope Moleküle auf oder besteht daraus, z.B. Moleküle mit isotroper Gestalt und/oder mit isotropem Dipolmoment und/oder mit isotroper Struktur, die z.B. strukturell, insbesondere chemisch, symmetrisch sind. Eine isotrope Molekülgestalt ist bevorzugt sphärisch und/oder weist ein Verhältnis von Länge zu Breite im Bereich von 0,6:1 bis 1,7:1 auf. Moleküle mit isotropem Dipolmoment haben z.B. ein permanentes Dipolmoment von maximal oder geringer als 0,5 Debye, bevorzugt von kleiner als 0,5 Debye bis 0 Debye. Moleküle von isotroper Struktur bzw. strukturell symmetrische Moleküle weisen bevorzugt eine Struktur auf, die sich einer der Symmetrieklassen der n-zahligen Rotation Cₙ, Inversion i, Spiegelung σ, oder einer Drehspiegelachse Sₙ zuordnen lässt, die z.B. auch als chemische Anisotropie bezeichnet wird.

Optional ist der erste Farbstoff ausgerichtet, dass sein Übergangsdipolmoment senkrecht zu dem Übergangsdipolmoment des zweiten Farbstoffs ausgerichtet ist und/oder parallel zur totalreflektierenden Grenzschicht. Diese Ausrichtung des ersten Farbstoffs kann z.B. dadurch erreicht werden, dass er aus Molekülen besteht, die anisotrop sind und deren Übergangsdipolmoment bei gleicher Ausrichtung des Moleküls um zumindest 70°, bevorzugt 80 bis 90° zum Übergangsdipolmoment des zweiten Farbstoffs angeordnet ist. Dies ist z.B. der Fall bei Kombinationen von einem ersten und einem zweiten Farbstoff, von denen bei dem einen das Übergangsdipolmoment parallel zur Achse der Anisotropie ist, und bei dem anderen Farbstoff das Übergangsdipolmoment im rechten Winkel dazu ist. Dabei bildet einer der Farbstoffe der Kombination den ersten Farbstoff und einer den zweiten Farbstoff.

Der Träger ist bevorzugt ein Kunststoff, z.B. Polyvinylalkohol (PVA), insbesondere in Form einer Folie. Der zweite Farbstoff kann in dem Träger in eine zueinander parallele Ausrichtung durch Einbringen des zweiten Farbstoffs in das Trägermaterial oder in ein Vorläufermaterial des Trägermaterials und anschließendes Recken des Trägermaterials gebracht werden. Die Ausrichtung der Moleküle des zweiten Farbstoffs wird gegenwärtig darauf zurückgeführt, dass das Recken, z.B. auf 200 % bis 400 % der ursprünglichen Länge, zu einer Ausrichtung entlang der Kunststoffmoleküle führt. Die Ausrichtung des Übergangsdipolmoments des zweiten Farbstoffs kann an dem Träger gemessen werden. Da die Ausrichtung eines zweiten Farbstoffs in dem Träger gemessen werden kann, ist auch eine Auswahl von Verbindungen als zweiter Farbstoff dadurch möglich, dass die Ausrichtung ihres Übergangsdipolmoments nach Herstellen des Trägers, z.B. mit dem Schritt des Reckens des Trägers, gemessen wird. Bevorzugt erfolgt das Recken in 1 Dimension bzw. in 1 Richtung, optional in 2 Dimensionen bzw. in 2 senkrecht aufeinander stehenden Richtungen.

Generell können der erste und zweite Farbstoff Cumarin-Derivate sein.

Als zweiter Farbstoff bevorzugte Verbindungen sind Cumarin 6, Acridingelb und Cresylviolett, z.B. Cresylviolettperchlorat. Diese Verbindungen werden durch Recken eines Trägers, der eine Kunststofffolie ist, im Wesentlichen in eine gemeinsame Orientierung ausgerichtet.

Generell kann der erste und/oder der zweite Farbstoff ein Nanopartikel sein, unabhängig voneinander z.B. aus Zink, Kadmium, Selen, Schwefel, Kohlenstoff oder aus zumindest zweien dieser. Bevorzugt weisen Nanopartikel eine Größe in ihrer längsten Dimension im Bereich von 1 bis 100 nm auf, z.B. von 5 bis 75 nm oder von 10 bis 50 nm. Die Größe der Nanopartikel wird bevorzugt durch Vermessen elektronenmikroskopischer Aufnahmen, insbesondere transmissions-elektronenmikroskopischer Aufnahmen, bestimmt. Auch Farbstoffe, die Nanopartikel sind, werden als Molekül in Bezug genommen, so dass die Isotropie bzw. Anisotropie der Farbstoffmoleküle sich auch auf Nanopartikel bezieht.

Der erste Farbstoff ist bevorzugt einer, der in dem Träger nicht ausgerichtet ist, sondern dessen Ausrichtung im Träger zufällig verteilt ist. Dies hat den Vorteil, dass der erste Farbstoff und ggf. ein dritter oder vierter Farbstoff auch diffus einfallendes Licht absorbieren.

Als erster bzw. dritter oder vierter Farbstoff bevorzugte Verbindungen, die sich z.B. nicht wesentlich durch Recken einer Trägerfolie, in der sie enthalten sind, in eine gemeinsame Orientierung ausrichten, sind Cumarin 1, Rhodamin 6G, Atto-390, Atto-465 und Atto-425. Als photovoltaisches Element sind, insbesondere für zweite Farbstoffe mit einem zweiten Emissionswellenlängenbereich von 522 nm, GaInP-photovoltaische Elemente bevorzugt. Für andere Wellenlängenbereiche sind auch GaAs-, InGaAs-, Ge- oder Si-photovoltaische Elemente bevorzugt.

Der transparente Festkörper kann aus Glas (Mineralglas) oder Kunststoff sein, z.B. Polyacrylat (Plexiglas), Polycarbonat oder Polyethylenterephthalat.

Generell eignet sich die erfindungsgemäße Vorrichtung zur Verwendung als Lichtkonzentrator für diffuses Licht.

Das energiewandelnde Element wird stellvertretend auch als photovoltaisches Element in Bezug genommen. Alternativ kann das energiewandelnde Element ein photokatalytisches Element sein, z.B. eines, das geeignet ist, mittels der Lichtenergie Wasser in seine Bestandteile Wasserstoff und Sauerstoff zu teilen oder Kohlendioxid mit Wasser in Kohlenwasserstoffe umzuwandeln oder geeignet ist, eine andere chemische Reaktion zu katalysieren, die die Lichtenergie nutzt, um höherenergetische oder andersartige chemische Produkte zu erhalten.

Generell kann vor einem Lichtkonzentrator ein optisches Element angeordnet sein, das diffuses Licht auf den Lichtkonzentrator leitet bzw. durchlässt und direktes bzw. kollimiertes Licht, insbesondere direktes Sonnenlicht, direkt auf zumindest ein photovoltaisches Element leitet. Eine Anordnung eines solchen optischen Elements im Strahlengang vor einem Lichtkonzentrator kann an jedem Lichtkonzentrator angeordnet sein. Wenn der Lichtkonzentrator eine erfindungsgemäße Vorrichtung ist, dann ist das optische Element bevorzugt so angeordnet, dass es diffuses Licht auf den Träger leitet bzw. durchlässt, und direktes bzw. kollimiertes Sonnenlicht direkt auf ein photovoltaisches Element leitet und direktes Licht vom Lichtkonzentrator, z.B. von dem Träger mit erstem und zweitem Farbstoff, abhält. Dies hat den Vorteil, dass direktes Sonnenlicht nicht die Farbstoffe belastet, die im Träger enthalten sind und dass das direkte Sonnenlicht auf das photovoltaische Element trifft. Dieses optische Element ist z.B. ein Hohlspiegel, eine Fresnellinse, bevorzugt eine Sammellinse.

In generell bevorzugter Ausführungsform weist die Vorrichtung parallel angeordnete Träger auf, z.B. Trägerfolien, die jeweils den ersten Farbstoff in zufälliger Ausrichtung und den zweiten Farbstoff enthalten, der parallel ausgerichtet ist, z.B. parallel zur Oberfläche des Trägers und bevorzugt parallel zur Richtung, in der der Träger gestreckt wurde, so dass der zweite Farbstoff so in dem Träger orientiert ist, dass dessen Übergangsdipolmomente in der Ebene des Trägers liegen. Zwischen den Trägern ist ein transparenter Festkörper angeordnet, der senkrecht zur Oberfläche des Trägers totalreflektierende Grenzflächen bildet, an denen aus der Oberfläche der Träger austretendes Licht reflektiert wird und auf ein photovoltaisches Element gelenkt wird, das bevorzugt parallel zur Oberfläche des Trägers und/oder senkrecht zur totalreflektierenden Oberfläche angeordnet ist. Das photovoltaische Element kann zentral innerhalb von Trägern angeordnet sein, die, jeweils mit dazwischen angeordneten transparenten Festkörpern, das photovoltaische Element umgeben. Generell bevorzugt sind die Träger parallel zu zumindest einem photovoltaischen Element angeordnet, weiter bevorzugt sind die Träger und das zumindest eine photovoltaische Element PV senkrecht zu einer totalreflektierenden Grenzflächen angeordnet, die von transparenten Festkörpern gebildet wird, die zwischen den Trägern und zwischen Trägern und dem photovoltaischen Element angeordnet sind. Dabei ist der zweite Farbstoff in dem Träger ausgerichtet, insbesondere so, dass die Übergangsdipolmomente der Moleküle des zweiten Farbstoffs zumindest in einer parallelen Ebene liegen, bevorzugt zueinander parallel ausgerichtet sind, und parallel zum photovoltaischen Element ausgerichtet sind. Weiter bevorzugt ist eine Vielzahl von Trägern zueinander parallel angeordnet, so dass z.B. der Abstand der Träger 3 voneinander die 0,2-fache bis 5-fache, z.B. die 0,5-fache bis 2-fache oder bis 1,5-fache, Höhe der Träger zwischen den totalreflektierenden Grenzflächen beträgt. Bevorzugt sind die Zwischenräume zwischen den Trägern und zwischen Träger und photovoltaischem Element durch transparente Festkörper ausgefüllt und diese Anordnung ist von Spiegeln umfasst, die das Licht des zweiten Emissionswellenlängenbereichs, das von den Trägern abgestrahlt wird, auf das photovoltaische Element lenken. Die Spiegel können z.B. senkrecht zu den totalreflektierenden Grenzflächen angeordnet sein. Die Spiegel können die Anordnung aus Trägern, deren Zwischenräume durch transparente Festkörper ausgefüllt sind, in Form hexagonal angeordneter Flächen umfassen, in deren Zentrum das photovoltaische Element angeordnet ist. Generell können sich die Träger über den vollständigen Abstand zwischen den totalreflektierenden Grenzflächen, die von den transparenten Festkörpern gebildet werden, erstrecken, z.B. jeweils parallel zueinander. Optional erstreckt sich dabei jeder Träger kontinuierlich zwischen einander gegenüberliegenden totalreflektierenden Grenzflächen, z.B. in jeweils einer Ebene oder gebogen, z.B. konvex oder konkav in Bezug zu einem photovoltaischen Element. Optional, insbesondere in Ausführungsformen, in denen ein energiewandelndes Element an einer Außenfläche transparenter Festkörper angeordnet ist, können Spiegel an der Außenfläche transparenter Festkörper jeweils gegenüber einem energiewandelnden Element und/oder angrenzend an ein energiewandelndes Element angeordnet sein.

In einer Ausführungsform sind zumindest zwei Träger, die sich jeweils nur über einen Anteil des Abstands zwischen den totalreflektierenden Grenzflächen erstrecken, voneinander mit Versatz senkrecht zu einem photovoltaischen Element und/oder mit Versatz voneinander entlang einer totalreflektierenden Grenzfläche angeordnet und weiter bevorzugt zusätzlich mit unterschiedlichem Abstand zur totalreflektierenden Grenzfläche. Dabei können die mit Versatz voneinander angeordneten Träger so bemessen sein, dass sich direkt benachbarte Träger nicht parallel zueinander überdecken. Bevorzugt sind die Träger in parallel zueinander angeordnet, in Ebenen oder jeweils gebogen. Die Zwischenräume zwischen den Trägern sind jeweils mit transparentem Festkörper ausgefüllt, der die totalreflektierenden Grenzflächen bildet. Eine Ausführungsform, in der zumindest zwei Träger senkrecht zur totalreflektierenden Grenzfläche und mit Versatz voneinander entlang der totalreflektierenden Grenzfläche angeordnet sind, hat den Vorteil, dass der erste Farbstoff mit größerer Effektivität diffus einfallendes Licht absorbiert.

Generell kann für die Zwecke der Erfindung eine Anordnung eines Trägers und/oder eines photovoltaischen Elements senkrecht zu einer totalreflektierenden Grenzfläche eine Anordnung in einem Winkel von 90 bis 60°, bevorzugt 90 bis 70° oder bis 80° zur totalreflektierenden Grenzfläche sein.

Optional können die einander gegenüberliegenden totalreflektierenden Grenzflächen des transparenten Festkörpers zueinander parallel angeordnet sein oder aufeinander zulaufen, z.B. in einem Winkel von maximal 30°, bevorzugt maximal 20° oder maximal 10°. Auch in solchen Ausführungsformen sind die zumindest zwei Träger bevorzugt parallel zueinander und optional parallel zu zumindest einem photovoltaischen Element und/oder einem Spiegel. Generell können die transparenten Festkörper miteinander verbunden oder einstückig sein. Generell bevorzugt enthalten die transparenten Festkörper keinen Farbstoff.

Generell ist der Träger optisch transparent, zumindest für sichtbares Licht, bevorzugt für eine Wellenlängenbereich von 100 bis 800 nm oder bis 750nm, oder von 150 oder 200 nm bis 800 oder bis 750 nm.

Generell können energiewandelnde Elemente (9) ausschließlich senkrecht zu der Ebene angeordnet sein, in der die Träger (3) angeordnet sind und bevorzugt ausschließlich senkrecht zu der Ebene der totalreflektierenden Grenzflächen (6) der transparenten Festkörper (7), alternativ können energiewandelnde Elemente (9) ausschließlich parallel zu der Ebene angeordnet sein, in der die Träger (3) angeordnet sind und bevorzugt ausschließlich senkrecht zu der Ebene der totalreflektierenden Grenzflächen (6) der transparenten Festkörper (7). Alternativ können energiewandelnde Elemente (9) jeweils senkrecht und parallel zu der Ebene angeordnet sein, in der die Träger (3) angeordnet sind, jeweils bevorzugt senkrecht zur Ebene der totalreflektierenden Grenzflächen (6) der transparenten Festkörper (7).

Generell können die Träger flächig sein. Alternativ können die Träger aus zumindest zwei stäbchenförmigen Elementen bestehen und in passenden Ausnehmungen, z.B. Bohrungen, im transparenten Festkörper angeordnet sein. Dabei kann der transparente Festkörper einstückig sein und in Ausnehmungen parallel angeordnete stäbchenförmige Elemente mit rechteckigem Querschnitt als Träger enthalten. Alternativ können die stäbchenförmigen Elemente einen runden Querschnitt aufweisen, z.B. für runde Bohrungen, die passende Ausnehmungen dafür bilden. Der zweite Farbstoff, insbesondere dessen Übergangsdipolmoment, kann parallel zur Längserstreckung stäbchenförmiger Elemente ausgerichtet sein. Die stäbchenförmigen Elemente können in gemeinsamen Ebenen, die z.B. parallel zueinander angeordnet sind, angeordnet sein. Alternativ können stäbchenförmige Elemente parallel und mit Versatz zueinander angeordnet sein, z.B. eine treppenförmige oder andere Anordnung aufweisen.

Die Erfindung wird nun genauer anhand von Beispielen mit Bezug auf die Figuren beschrieben, die in
- Figur 1 schematisch das Funktionsprinzip einer erfindungsgemäßen Vorrichtung und das Verfahrens,
- Figur 2 schematisch eine bevorzugte Ausführungsform der erfindungsgemäßen Vorrichtung und des Verfahrens,
- Figur 3 schematisch eine weitere bevorzugte Ausführungsform der erfindungsgemäßen Vorrichtung und des Verfahrens,
- Figur 4 bei a-f, g-h, i-m, o-q (ohne n) Analysenergebnisse für einen beispielhaften Träger in Form einer PVA-Folie mit parallel gerichteten zweiten Farbstoffen und zufällig orientierten ersten Farbstoffen im Vergleich mit einer Folie, in der der zweite Farbstoff nicht parallel ausgerichtet ist,
- Figur 5 Absorptions- und Emissionsspektren eines ersten und eines zweiten Farbstoffs,
- Figur 6 bei a-d bevorzugte Ausführungsformen,
- Figur 7 eine bevorzugte Ausführungsform und
- Figur 8 eine weitere Ausführungsform,
- Figuren 9 bis 11 weitere Ausführungsformen zeigen.

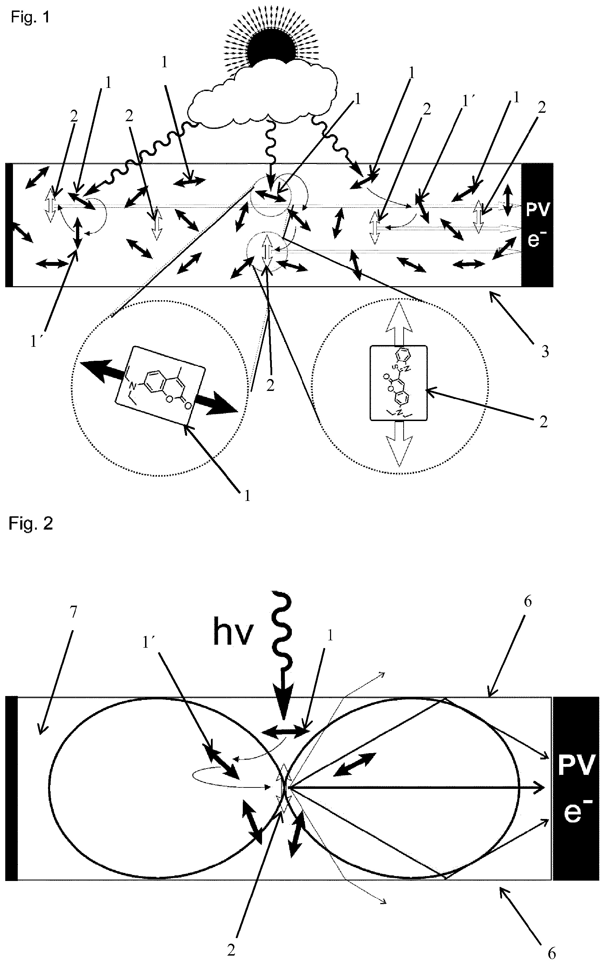

In den Figuren steht ein photovoltaisches Element stellvertretend für ein energiewandelndes Element. In Figuren 1-3 sind die Übergangsdipolmomente des ersten Farbstoffs durch gefüllte Doppelpfeile dargestellt, die Übergangsdipolmomente des zweiten Farbstoffs als hohle Doppelpfeile.

Die Figur 1 zeigt die Einstrahlung von diffusem Sonnenlicht auf Moleküle eines ersten Farbstoffs 1, die in Mischung mit Molekülen eines zweiten Farbstoffs 2 in einem Träger 3 enthalten sind. Dargestellt sind die Ausrichtungen der Übergangsdipolmomente, nämlich entsprechend der bevorzugten Ausführungsform die zufällige Ausrichtung des ersten Farbstoffs 1 und die Ausrichtung des zweiten Farbstoffs 2 so, dass diese Moleküle bzw. deren Übergangsdipolmomente parallel zueinander gleich ausgerichtet sind, in Figur 1 vertikal dargestellt. Die ausschnittsweisen schematischen Vergrößerungen zeigen, dass im Falle von Cumarin 1 als erstem Farbstoff 1 die Moleküle auch nach dem Recken der Trägerfolie eine zufällig verteilte Ausrichtung aufweisen und im Falle von Cumarin 6 als zweitem Farbstoff 2 die Molekülachse in Richtung der Verstreckung 4 des Trägers 3 liegt und etwa parallel zum Übergangsdipolmoment. Schematisch dargestellt ist, dass diffuses Licht von verschieden ausgerichteten ersten Farbstoffmolekülen 1 absorbiert wird und auf zweite Farbstoffmoleküle 2 übertragen wird, z.B. durch den direkten Energietransfer nach Förster. Von ersten Farbstoffmolekülen 1 emittiertes Licht kann auch direkt von zweiten Farbstoffmolekülen 2 absorbiert werden. Die vom ersten Farbstoffmolekülen 1 absorbierte Energie kann auch zunächst von einem anderen ersten Farbstoffmolekül 1' aufgenommen und erst dann von einem zweiten Farbstoffmolekül 2 aufgenommen werden. Die zweiten Farbstoffmoleküle 2 emittieren auf Grund ihrer parallelen Ausrichtung bevorzugt in parallelen Ebenen bzw. entlang gemeinsamer Graden. Das emittierte Licht fällt auf ein photovoltaisches Element PV, das in der Ebene der Emission des zweiten Farbstoffs liegt und kann dort elektrischen Strom erzeugen.

Die Figur 2 zeigt schematisch die Absorption von einfallendem Licht durch ein erstes Farbstoffmolekül 1 und die Energieübertragung vom ersten Farbstoffmolekül 1 zunächst auf ein weiteres erstes Farbstoffmolekül 1' und schließlich auf das zweite Farbstoffmolekül 2, das ausgerichtet ist. Die totalreflektierenden Grenzflächen 6 eines transparenten Festkörpers 7, der gleichzeitig der Träger 3 der Farbstoffe 1, 2 sein kann oder der an einen Träger 3 angrenzt, reflektieren den Anteil der Emission des zweiten Farbstoffs 2, der nicht genau senkrecht zu dessen Übergangsdipolmoment emittiert wird, um diesen Anteil auf ein photovoltaisches Element PV zu richten. Generell können der Träger 3 und der transparente Festkörper 7 einstückig ausgebildet sein.

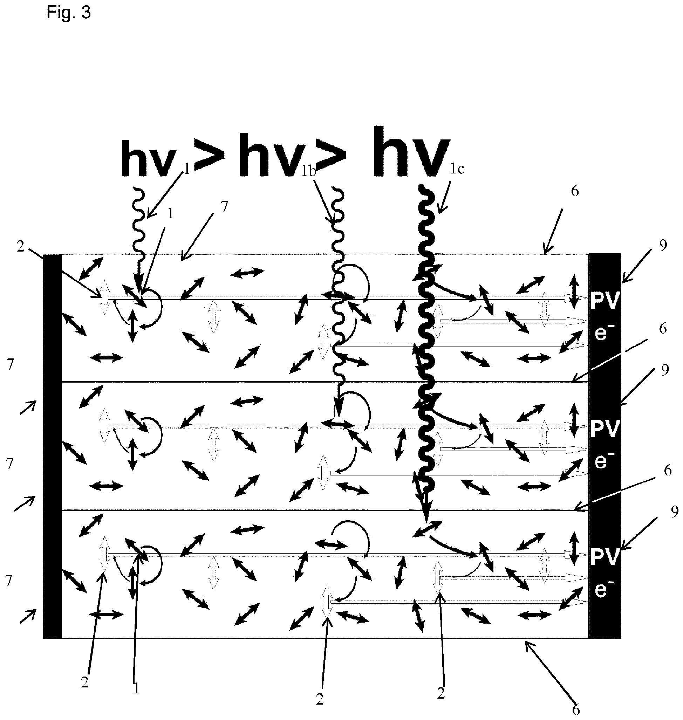

Die Figur 3 zeigt eine Ausführungsform, bei der drei transparente Festkörper 7 und/oder Träger 3 und/oder transparente Festkörper 7, zwischen deren Abschnitten jeweils Träger 3 angeordnet sind, die jeweils einen zweiten Farbstoff 2 in paralleler Ausrichtung enthalten, angeordnet sind. Die totalreflektierenden Oberflächen jedes Festkörpers 7 sind von einer Luftschicht umgeben. Jeder der transparenten Festkörper 7 und/oder der Träger 3 enthält jeweils einen ersten Farbstoff 1, einen dritten Farbstoff 1b bzw. einen vierten Farbstoff 1c, der jeweils in zufälliger Ausrichtung in dem Träger 3 enthalten ist und in einem anderen Absorptionswellenlängenbereich (hν₁ > hν_{1b} > hν_{1c}) absorbiert. Die Festkörper 7 bzw. Träger 3 mit dem jeweils unterschiedlichen ersten Farbstoff 1 bzw. dritten oder vierten Farbstoff 1b, 1c sind im Verhältnis zum einfallenden Licht übereinander angeordnet, so dass auf kleiner Fläche der jeweils nicht vom ersten Farbstoff absorbierte Wellenlängenbereich des einfallenden Lichts durch den Träger 3 treten kann und von dem dritten 1b bzw. darunterliegenden vierten Farbstoff 1c entsprechend seines Absorptionswellenlängenbereichs absorbiert wird. Jeder der ersten bzw. dritten Farbstoffe 1, 1b, 1c kann generell im gleichen oder in einem anderen Emissionswellenlängenbereich emittieren, der sich jeweils mit dem zweiten Absorptionswellenlängenbereich überdeckt, den der jeweils in dem Träger enthaltene zweite Farbstoff 2 aufweist.

### Beispiel: Herstellung eines Trägers mit einem ersten Farbstoff und einem ausgerichteten zweiten Farbstoff, dessen Moleküle parallel zueinander ausgerichtet sind

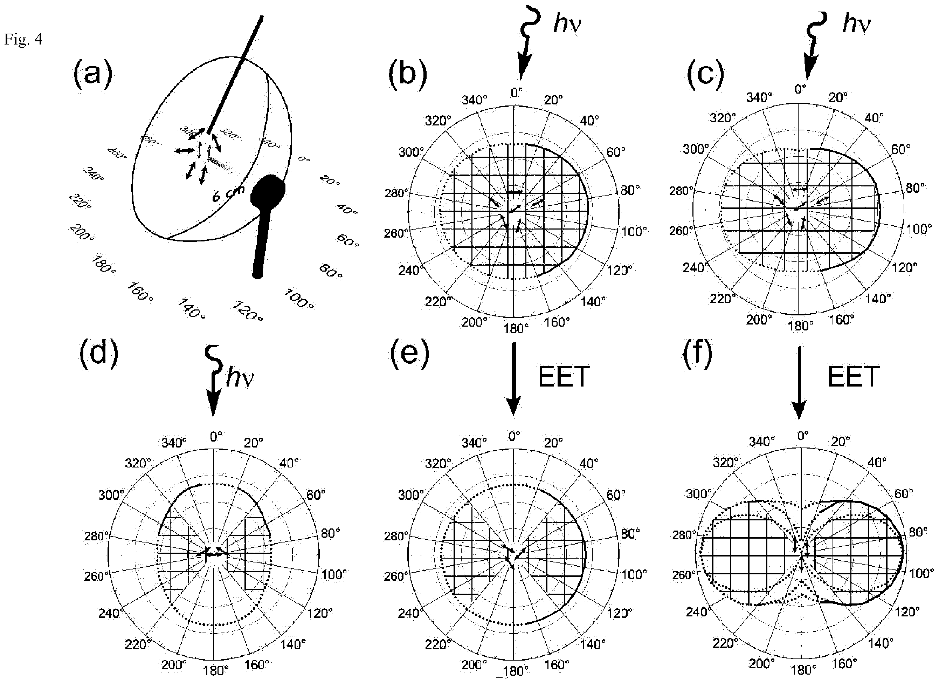

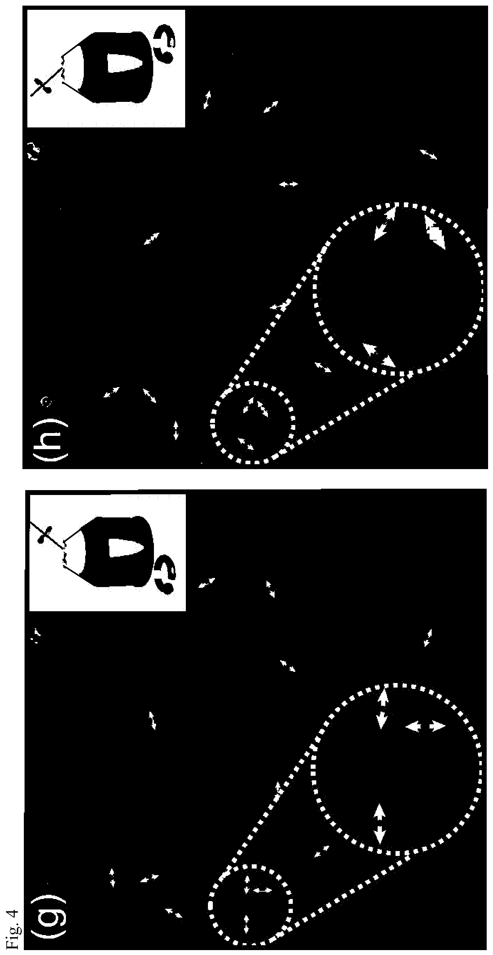

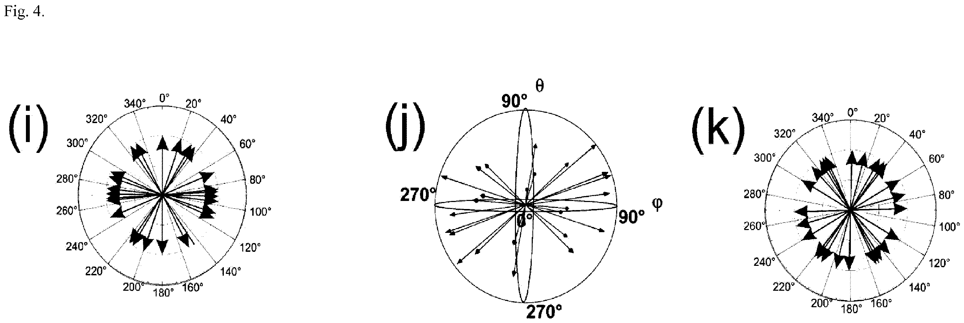

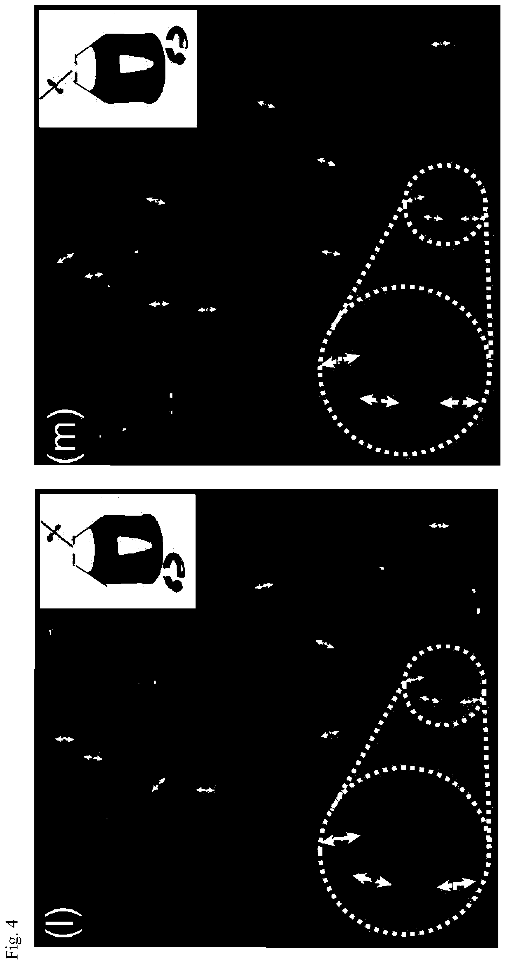

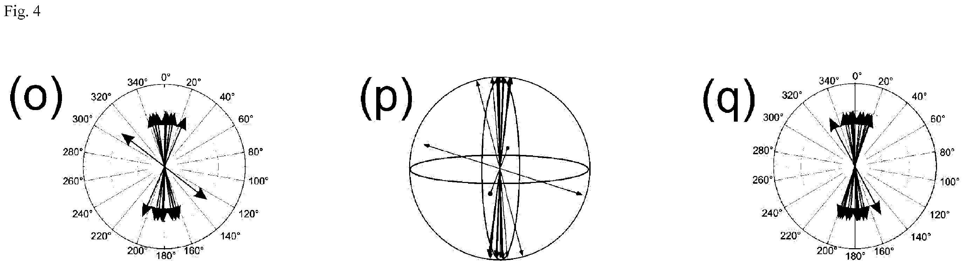

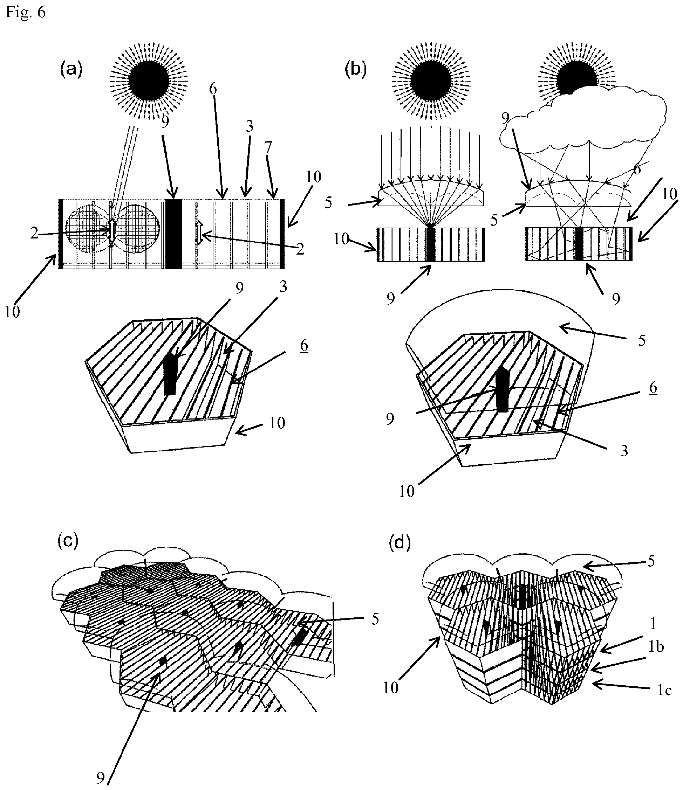

Ein Träger in Form einer PVA-Folie mit Cumarin 1 als erstem Farbstoff (Donor) ohne räumliche Ausrichtung und Cumarin 6 als zweitem Farbstoff (Akzeptor) in einheitlicher paralleler Ausrichtung wurde durch die folgenden Schritte hergestellt: 22 Gew.-% PVA wurden in einer Mischung aus Wasser und DMSO (Dimethylsulfoxid) 20:80 (10 mL) bei 140 °C für 2 h in einer N₂-Atmosphäre gelöst. Nach Abkühlen unter Rühren wurden 0,0035 g Cumarin 6 und 0,0175 g Cumarin 1 in 8 mL DMSO und 2 mL Wasser gelöst und per Ultraschall entgast. Die gelösten Farbstoffe wurden in die PVA-Lösung eingemischt und die Mischung wurde zu 2 bis 3 g auf Glasplatten gegossen und durch Schwenken verteilt, dann bei 40 °C im Trockenschrank getrocknet. Die getrocknete Folie wurde um 400 % in einer Richtung gereckt und wies eine Dicke von ca. 50 µm auf. Solchermaßen hergestellte Träger 3, die zwischen transparenten Festkörpern 7 angeordnet sind, sind in Fig. 6 schematisch gezeigt. Die Figur 4 zeigt in c, f, l, m, o, p, q Analysenergebnisse, die für die gereckte Folien bestimmt wurden und in b, e, d, g, h, i, j, k Analysenergebnisse, die für eine nicht gereckte Vergleichsfolie, die ansonsten identisch war, bestimmt wurden. Die Figuren 4 b - f zeigen die winkelabhängigen Verteilungen der absoluten Intensitäten, die von Donor- und Akzeptormolekülen emittiert wurden. Zur Messung wurde ein kalibriertes Leistungsmessgerät verwendet (schematisch in Fig. 4a). Die direkte Anregung der Akzeptormoleküle in der Vergleichsfolie zeigte eine bevorzugte ungünstige Emission in derselben Richtung wie die Anregung (Fig. 4d). Die Messung der Emission der Akzeptormoleküle in der Vergleichsfolie ergab, dass ein Energietransfer von den Donormolekülen auftrat. Die winkelspezifische Messung ergab für die Vergleichsfolie, dass die Emission der Akzeptormoleküle eine isotrope Winkelverteilung aufwies (Fig. 4 e). Auch die verbleibende Emission der Donormoleküle zeigte eine nahezu isotrope Verteilung (Fig. 4 b).

Die Messungen mit der erfindungsgemäß gereckten Folie zeigten, dass die verbleibende Emission der Donormoleküle (Fig. 4 c) kaum eine räumliche Ausrichtung aufwies. Die Emission der Akzeptormoleküle (Fig. 4 f) war eindeutig anisotrop.

Diese Ergebnisse machen deutlich, dass die Donormoleküle (erster Farbstoff) in dem erfindungsgemäßen Träger im Wesentlichen zufällig ausgerichtet sind und dass die Akzeptormoleküle (zweiter Farbstoff) im Wesentlichen in derselben Ausrichtung bzw. parallel zueinander ausgerichtet waren. Die Ergebnisse zeigen auch den effektiven Energietransfer vom Donor zum Akzeptor.

Die Figuren 4 l und 4 m zeigen für die gereckte Folie die um den Hintergrund korrigierten Signale einzelner Moleküle, deren 3D-Orientierung durch Einstrahlung von Anregungsstrahlung mit modulierter Polarisation in zwei zueinander geneigten Einfallswinkeln gemessen wurde, in Figuren 4 g und 4 h für die Vergleichsfolie. Dargestellt sind jeweils die gemessenen Übergangsdipolmomente. Die Ergebnisse machen deutlich, dass in der gereckten Folie die Akzeptormoleküle (zweiter Farbstoff) in allen drei Dimensionen gleich bzw. parallel ausgerichtet sind, während in der Vergleichsfolie die Akzeptormoleküle (zweiter Farbstoff) eine isotrope Orientierungsverteilung zeigen.

Absorptionsmessungen zeigten, dass etwa 99 % des Lichts im Maximum der Donorabsorption von der gereckten Folie absorbiert wurden.

Eine Abschätzung der Quanteneffizienz des Energietransfers nach vier verschiedenen Verfahren ergab eine Effizienz für die gereckte Folie von 80% -100%.

Ca. 90 % der vom Akzeptor emittierten Photonen wurden in einem Winkel abgestrahlt, der die Lichtleitung durch Totalreflexion erlaubt. Wenn die Emission von Donor (erster Farbstoff) und Akzeptor (zweiter Farbstoff), die in einem Winkelbereich zur vollständigen inneren Reflexion liegt, und der Anteil absorbierten Lichts berücksichtigt wird, zeigen die Effizienzen des Energietransfers und die Fluoreszenzquantenausbeute der beiden Farbstoffe, dass bevorzugt mindestens ca. 66 % aller von der Trägerfolie absorbierten Photonen in einem Winkel abgestrahlt werden, der die Lichtleitung durch Totalreflexion erlaubt, mit einer Effizienz der Photonenabsorption im Maximum der Donorabsorption von 99 % und vernachlässigbarer Re-absorption. Bei Berücksichtigung der Photonenenergie von Donor und Akzeptor entspricht dies einer Energieeffizienz von mindestens ca. 50 %.

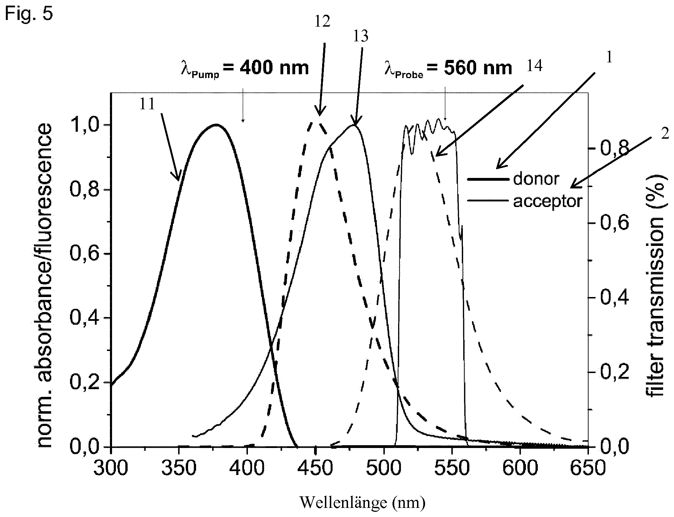

Die Figur 5 zeigt den ersten Absorptionswellenlängenbereich 11 des ersten Farbstoffs (Cumarin 1) und dessen ersten Emissionswellenlängenbereich 12, der sich mit dem zweiten Absorptionswellenlängenbereich 13 des zweiten Farbstoffs (Cumarin 6) überdeckt. Der zweite Emissionswellenlängenbereich 14 des zweiten Farbstoffs überdeckt sich bevorzugt mit dem Absorptionswellenlängenbereich eines photovoltaischen Elements wie GaInP.

Die Figur 6 zeigt schematisch generell bevorzugte Vorrichtungen mit parallel angeordneten Trägerfolien 3, die jeweils den ersten Farbstoff 1 und den zweiten Farbstoff 2 enthalten, wobei der zweite Farbstoff 2 so in dem Träger orientiert ist, dass dessen Übergangsdipolmomente, angedeutet durch den Doppelpfeil, in der Ebene des Trägers 3 und im Bild vertikal liegen. Solche Träger 3 in Form von Folien sind nach dem Verfahren des Beispiels herstellbar. Zwischen den Trägern 3 ist Plexiglas als transparenter Festkörper 7 angeordnet, das totalreflektierende Grenzflächen 6 bildet, an denen aus der Oberfläche der Träger 3 austretendes Licht reflektiert wird und auf das zentral angeordnete photovoltaische Element 9 gelenkt wird.

Generell bevorzugt sind die Träger 3 parallel zu zumindest einem photovoltaischen Element PV angeordnet, weiter bevorzugt sind die Träger 3 und das zumindest eine photovoltaische Element PV senkrecht zu einer totalreflektierenden Grenzflächen 6 angeordnet, die von transparenten Festkörpern 7 gebildet wird, die zwischen den Trägern 3 und zwischen Trägern 3 und dem photovoltaischen Element PV angeordnet sind. Dabei ist der zweite Farbstoff 2 in dem Träger 3 ausgerichtet, insbesondere so, dass die Übergangsdipolmomente der Moleküle des zweiten Farbstoffs 2 zueinander parallel und parallel zum photovoltaischen Element PV ausgerichtet sind. Weiter bevorzugt ist eine Vielzahl von Trägern 3 zueinander parallel angeordnet, z.B. so dass der Abstand der Träger 3 voneinander die 0,2-fache bis 5-fache, z.B. die 0,5-fache bis 2-fache oder bis 1,5-fache, Höhe der Träger beträgt, die zwischen den totalreflektierenden Grenzflächen 6 bestimmt wird.

Bevorzugt ist eine Anordnung von Trägern 3, deren Zwischenräume durch transparente Festkörper 7 ausgefüllt sind, von Spiegeln 10 umfasst, die gemeinsam mit den totalreflektierenden Grenzflächen 6 der transparenten Festkörper 7 das Licht des zweiten Emissionswellenlängenbereichs, das von den Trägern 3 abgestrahlt wird, auf das photovoltaische Element 9 lenkt. Die Spiegel 10 können z.B. senkrecht zu den totalreflektierenden Grenzflächen 6 angeordnet sein. Die Spiegel 10 können die Anordnung aus Trägern 3, deren Zwischenräume durch transparente Festkörper 7 ausgefüllt sind, in Form hexagonal angeordneter Flächen umfassen, in deren Zentrum das photovoltaische Element 9 angeordnet ist.

Wie in Figur 6a im Schnitt und in perspektivischer Ansicht gezeigt ist, können generell die Träger 3, das photovoltaische Element 9 und die Spiegel 10 jeweils senkrecht zu den totalreflektierenden Grenzflächen 6 angeordnet sein. Wie in Figur 6b im Schnitt und in perspektivischer Ansicht gezeigt ist, können generell das photovoltaische Element 9 und die Spiegel 10 jeweils senkrecht zu den totalreflektierenden Grenzflächen 6 angeordnet sein und die Träger 3 zwischen diesen geneigt angeordnet sein, wobei ihre Zwischenräume von dem transparenten Festkörper 7 ausgefüllt sind, die die totalreflektierenden Grenzflächen 6 bilden. Generell bevorzugt Träger 3 in einer Anordnung angeordnet, in der ein photovoltaisches Element 9 angeordnet ist, das vom zweiten Farbstoff emittiertes Licht erhält. Dabei überdeckt das photovoltaische Element 9 bevorzugt die Ebene, in die der zweite Farbstoff Licht emittiert und in die vom zweiten Farbstoff emittiertes Licht durch totalreflektierende Grenzflächen 6 geleitet wird. Weiter bevorzugt ist die Anordnung der Träger von Spiegeln 10 eingefasst, die z.B. hexagonal angeordnet sind, wobei die Spiegel 10 Licht in Richtung auf das photovoltaische Element 9 leiten.

Die Figur 6c zeigt eine Anordnung von Vorrichtungen gemäß Figuren 6a oder 6b, die nebeneinander angeordnet sind.

Die Figur 6d zeigt eine Anordnung von Vorrichtungen gemäß Figuren 6a oder 6b, die übereinander angeordnet sind, wobei die übereinander angeordneten Träger 3 in Kombination mit einem parallel ausgerichteten zweiten Farbstoff 2 einen ersten Farbstoff 1 bzw. einen dritten Farbstoff 1b oder einen vierten Farbstoff 1c aufweisen, die unterschiedliche Absorptionswellenlängenbereiche haben, wie dies entsprechend auch in Figur 3 dargestellt ist. Dabei grenzen totalreflektierende Grenzflächen 6 als Oberflächen an Luft. Figur 6 zeigt am Beispiel eines Lichtkonzentrators ein optisches Element 5, das diffuses Licht (Fig. 4b, rechtes Bild) durchlässt und direktes Licht, insbesondere Sonnenlicht auf das photovoltaische Element 9 leitet und daher vom Lichtkonzentrator, insbesondere vom Träger 3, abhält. Der Lichtkonzentrator, der für die Anordnung mit diesem optischen Element unabhängig von der Ausgestaltung des Lichtkonzentrators ist, ist beispielhaft ein Träger 3 mit einem ersten Farbstoff 1 und einem zweiten Farbstoff 2, dessen Moleküle parallel zueinander ausgerichtet sind, wobei ein photovoltaisches Element 9 so angeordnet ist, dass vom zweiten Farbstoff emittiertes Licht des zweiten Emissionswellenlängenbereichs darauf trifft. Vorliegend ist dieses optische Element durch zumindest eine Sammellinse gebildet, die zwischen der Lichtquelle und dem Lichtkonzentrator, der die Träger 3 aufweist, angeordnet ist. Das optische Element 5 kann zumindest eine Sammellinse oder eine Fresnellinse oder ein Hohlspiegel sein und so angeordnet sein, dass direkt auf den Lichtkonzentrator gerichtetes direktes Licht, insbesondere direktes, kollimiertes Sonnenlicht, direkt auf das photovoltaische Element 9 geleitet wird, und nur diffuses Licht auf den Lichtkonzentrator fällt.

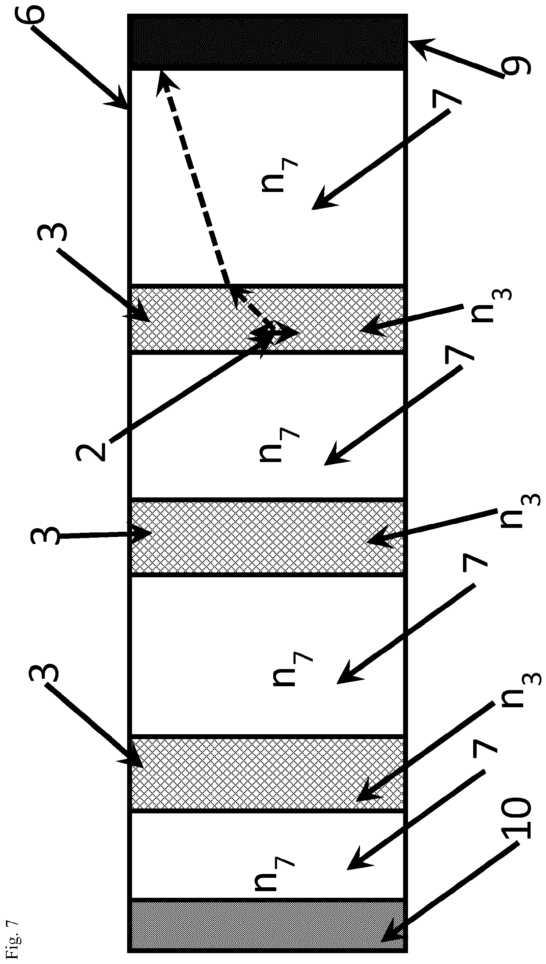

Die Figur 7 zeigt schematisch den Vorteil der bevorzugten parallelen Anordnung der Träger 3 und des zumindest einen photovoltaischen Elements 9, optional eines Spiegels 10 gegenüber dem photovoltaischen Element 9, jeweils senkrecht zu den totalreflektierenden Grenzflächen 6 des transparenten Festkörpers 7, der jeweils zwischen den Trägern 3 und zwischen einem Träger 3 und dem photovoltaischen Element 9 angeordnet ist. Von zweitem Farbstoff 2, der in den Trägern 3 mit seinem Übergangsdipolmoment parallel zum Träger 3 bzw. zur Ebene des Trägers 3 ausgerichtet ist, ausgestrahltes Licht wird von dem transparenten Festkörper 7 in Richtung auf das photovoltaische Element 9 gebeugt und in einen Winkel gebeugt, der auch zur Reflexion an den totalreflektierenden Grenzflächen 6 geeignet ist.

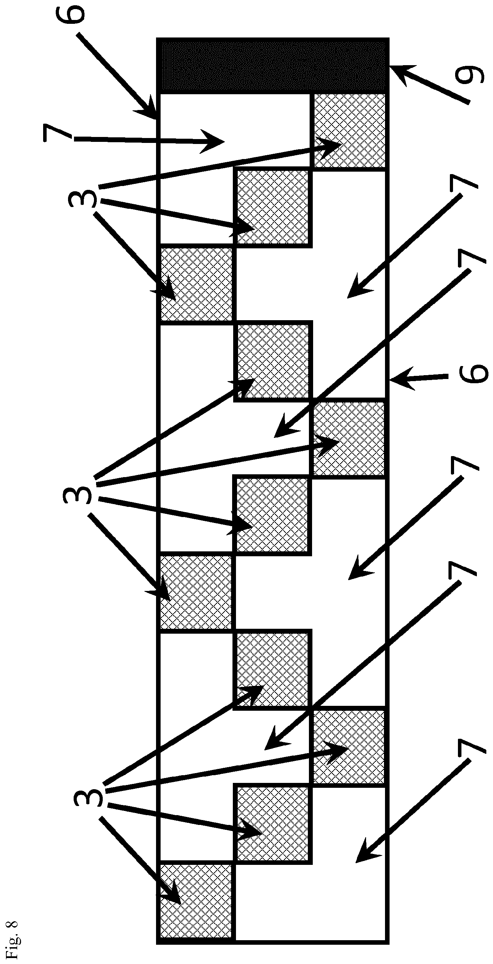

Die Figur 8 zeigt eine Ausführungsform, in der drei Träger 3 mit Versatz entlang der totalreflektierenden Grenzfläche 6 zueinander angeordnet sind, die sich jeweils nur über einen Anteil des Abstands zwischen den totalreflektierenden Grenzflächen 6 erstrecken. Wie bevorzugt sind die Träger 3 jeweils in parallelen Ebenen angeordnet. Die Zwischenräume zwischen den Trägern 3 sind jeweils mit transparenten Festkörpern 7 ausgefüllt, die die totalreflektierenden Grenzflächen 6 bilden.

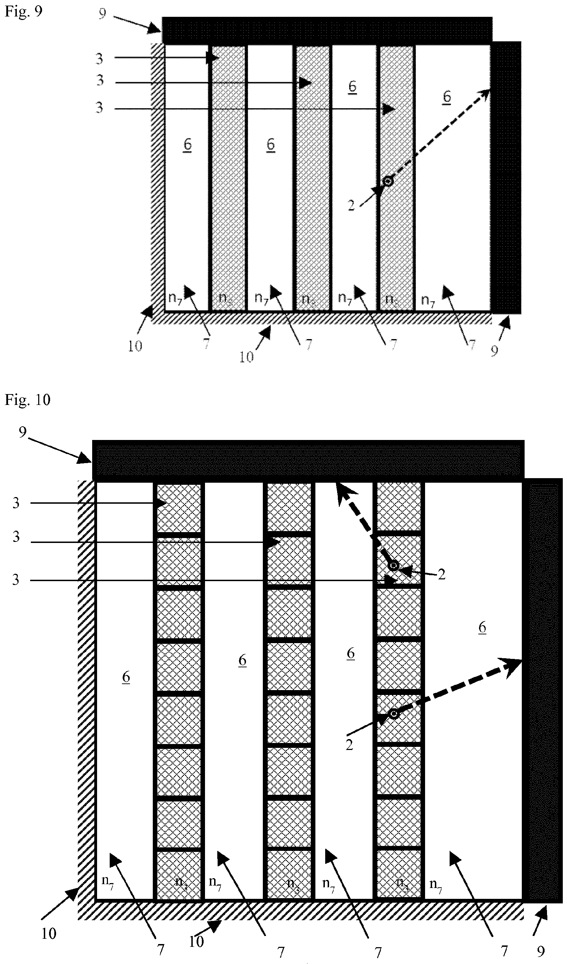

In Figuren 9-11 ist bespielhaft ein zweites Farbstoffmolekül 2 angedeutet, dessen Übergangsdipolmoment senkrecht zur Zeichnungsebene ausgerichtet ist. Von zweiten Farbstoffmolekülen emittiertes Licht ist ausschnittsweise durch gestrichelte Pfeile angedeutet.

Die Figur 9 zeigt in Aufsicht auf die totalreflektierende Grenzfläche 6, dass ein energiewandelndes Element 9 bevorzugt senkrecht zur totalreflektierende Grenzfläche 6 des transparenten Festkörpers 7 angeordnet ist, optional ein energiewandelndes Element 9 ausschließlich senkrecht zu der Ebene, in der flächige Träger 3 angeordnet sind oder ausschließlich parallel zu der Ebene angeordnet sind, in der flächige Träger 3 angeordnet sind, und dass optional energiewandelnde Elemente 9 sowohl parallel als auch senkrecht zu der Ebene angeordnet sind, in der flächige Träger 3 angeordnet sind. Die Träger 3 sind parallel zueinander angeordnet und ihre Zwischenräume sind von transparenten Festkörpern ausgefüllt, deren Oberflächen, die senkrecht zu den Trägern 3 liegen, totalreflektierende Grenzflächen 6 bilden.

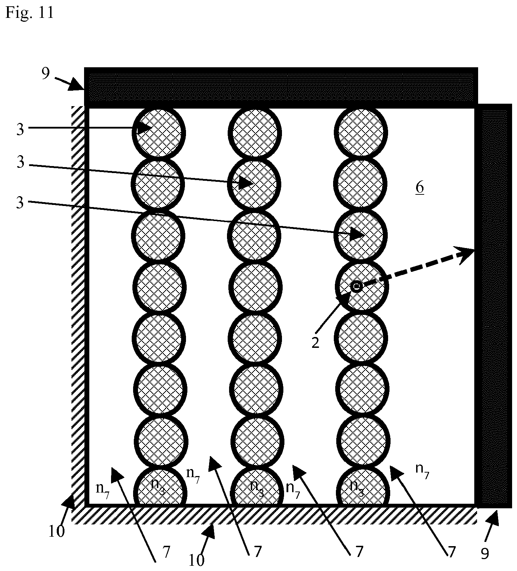

Die Figuren 10 und 11 zeigen Ausführungsformen in Aufsicht auf die totalreflektierende Grenzfläche 6 des transparenten Festkörpers 7, der einstückig ausgebildet sein kann, wobei der transparente Festkörper 7 senkrecht zur totalreflektierenden Grenzfläche 6 angeordnete Ausnehmungen aufweist, in denen stabförmige Träger 3 angeordnet sind. Diese Träger 3 und die dazu passenden Ausnehmungen weisen in der Ausführungsform von Figur 10 einen runden Querschnitt auf und in der Ausführungsform von Figur 11 einen viereckigen Querschnitt. Die stabförmigen Träger 3 können in jeweils parallelen Ebenen angeordnet sein. Die stabförmigen Träger 3 können aneinander angrenzend angeordnet sein oder voneinander beabstandet sein, wobei Zwischenräume zwischen ihnen generell von transparentem Festkörper 7 ausgefüllt sind. Wie hier dargestellt ist, sind energiewandelnde Elemente 6 bevorzugt senkrecht zur totalreflektierenden Oberfläche 6 angeordnet. Energiewandelnde Elemente 6 sind an zumindest einer Oberfläche der transparenten Festkörper 7 angeordnet, optional an zwei in einem Winkel von z.B. 90° zueinander angeordneten Oberflächen.

Die Figuren 9 bis 11 zeigen, dass bevorzugt Spiegel 10 an den zur totalreflektierenden Oberfläche 6 senkrechten Oberflächen der transparenten Festkörper 7 angeordnet sind, an denen keine energiewandelnde Elemente 6 angeordnet sind. Diese, zur totalreflektierenden Oberfläche 6 senkrechten Oberflächen der transparenten Festkörper 7 können anteilig von Trägern 3 gebildet sein, die in Ausnehmungen im transparenten Festkörper 7 angeordnet sind, z.B. die unten in Fig. 10 angeschnittenen Träger 3, an denen exemplarisch ein Spiegel 10 angebracht ist.

### Bezugszeichen:

1, 1', 1b, 1c erster, dritter, vierter Farbstoff
2 zweiter Farbstoff
3 Träger
5 optisches Element
6 totalreflektierende Grenzfläche
7 transparenter Festkörper
9, PV, energiewandelndes, insbesondere photovoltaisches Element
10 Spiegel
11 erster Absorptionswellenlängenbereich
12 erster Emissionswellenlängenbereich
13 zweiter Absorptionswellenlängenbereich
14 zweiter Emissionswellenlängenbereich

## Patentansprüche

1. Vorrichtung zum Leiten von Licht, die einen transparenten Träger (3) aufweist, in dem ein erster Farbstoff (1, 1') verteilt ist, der einen ersten Absorptionswellenlängenbereich (11) und einen ersten Emissionswellenlängenbereich (12) aufweist, und ein zweiter Farbstoff (2) verteilt ist, der aus anisotropen Molekülen besteht und der einen zweiten Absorptionswellenlängenbereich (13) und einen zweiten Emissionswellenlängenbereich (14) aufweist, wobei die Übergangsdipolmomente des zweiten Farbstoffs (2) eine räumliche Ausrichtung aufweisen, in der sie in einem Winkel von maximal 30° zueinander angeordnet sind, und parallel zu der Ebene, in der die Übergangsdipolmomente des zweiten Farbstoffs (2) ausgerichtet sind, ein energiewandelndes Element (9) angeordnet ist, **dadurch gekennzeichnet, dass** der erste Farbstoff (1, 1') in dem Träger (3) in zufällig verteilter Ausrichtung enthalten ist und sich der erste Emissionswellenlängenbereich (12) und der zweite Absorptionswellenlängenbereich (13) zumindest anteilig überlappen, oder dass die Moleküle des ersten Farbstoffs (1, 1') in dem Träger (3) dieselbe räumliche Ausrichtung aufweisen, in der sie in einem Winkel von maximal 30° zueinander angeordnet sind und sich der erste Emissionswellenlängenbereich (12) und der zweite Absorptionswellenlängenbereich (13) zumindest anteilig überlappen.

2. Vorrichtung nach Anspruch 1, **dadurch gekennzeichnet, dass** die Moleküle des ersten Farbstoffs (1, 1') in dem Träger (3) dieselbe räumliche Ausrichtung aufweisen, in der sie in einem Winkel von maximal 20°, maximal 10° oder maximal 2° zueinander angeordnet sind.

3. Vorrichtung nach einem der voranstehenden Ansprüche, **dadurch gekennzeichnet, dass** zwischen zumindest zwei Trägern (3) ein transparenter Festkörper (7) angeordnet ist, dessen Stirnflächen, die nicht parallel zu den Trägern (3) sind, totalreflektierende Grenzflächen (6) bilden, die eingerichtet sind, das emittierte Licht des zweiten Emissionswellenlängenbereichs (14) zu dem energiewandelnden Element (9) zu lenken.

4. Vorrichtung nach Anspruch 3, **dadurch gekennzeichnet, dass** in dem Träger (3) der erste Farbstoff (1, 1') mit seinen Übergangsdipolmomenten parallel zur totalreflektierenden Grenzfläche (6) ausgerichtet ist.

5. Vorrichtung nach einem der Ansprüche 3 bis 4, **dadurch gekennzeichnet, dass** in einem Winkel zu der Ebene, in der die Übergangsdipolmomente der Moleküle des zweiten Farbstoffs (2) angeordnet sind, die zumindest eine totalreflektierende Grenzschicht (6) angeordnet ist, die emittiertes Licht des zweiten Emissionswellenlängenbereichs (14) zu einem photovoltaischen Element (9) lenkt.

6. Vorrichtung nach einem der voranstehenden Ansprüche, **gekennzeichnet durch** ein optisches Element (5), das eingerichtet ist, direktes, kollimiertes Licht direkt auf zumindest ein energiewandelndes Element (9) zu leiten und diffus gestreutes Licht auf einen Träger (3) zu leiten oder treffen zu lassen.

7. Vorrichtung nach einem der voranstehenden Ansprüche, **gekennzeichnet durch** zumindest einen dritten Farbstoff (1b), der jeweils einen dritten Absorptionswellenlängenbereich aufweist und in einem transparenten Träger (3) verteilt ist, wobei der jeweils dritte Absorptionswellenlängenbereich sich zu maximal 10 % mit dem ersten Absorptionswellenlängenbereich (11) des ersten Farbstoffs (1) überdeckt und in dem Träger (3) der zweite Farbstoff (2) verteilt ist, dessen Moleküle jeweils dieselbe räumliche Ausrichtung aufweisen.

8. Vorrichtung nach Anspruch 7, **dadurch gekennzeichnet, dass** der dritte Farbstoff (1b) in demselben Träger (3) wie der erste (1, 1') und zweite Farbstoff (2) verteilt ist oder in einem zweiten transparenten Träger (3) verteilt ist, wobei in dem Träger (3) ein zweiter Farbstoff (2), der einen zweiten Emissionswellenlängenbereich (14) aufweist und in dem Träger (3) verteilt ist, und dadurch, dass die Moleküle des zweiten Farbstoffs (2) jeweils dieselbe räumliche Ausrichtung aufweisen und in einer gemeinsamen Ebene emittieren.

9. Vorrichtung nach einem der Ansprüche 7 bis 8, **dadurch gekennzeichnet, dass** der zumindest eine dritte Farbstoff (1b) jeweils einen dritten Emissionswellenlängenbereich und der zweite Farbstoff (2) einen zweiten Absorptionswellenbereich (13) haben und sich der jeweils dritte Emissionswellenlängenbereich und der zweite Absorptionswellenlängenbereich (14) zumindest anteilig überdecken.

10. Vorrichtung nach einem der voranstehenden Ansprüche, **dadurch gekennzeichnet, dass** der erste Farbstoff (1) und/oder der zweite Farbstoff (2) Nanopartikel sind.

11. Vorrichtung nach einem der voranstehenden Ansprüche, **dadurch gekennzeichnet, dass** zumindest zwei Träger (3) parallel angeordnet sind und dass Spiegel (10) angeordnet sind, die das emittierte Licht des zweiten Emissionswellenlängenbereichs (14) zu einem energiewandelnden Element (9) lenken.

12. Vorrichtung nach einem der Ansprüche 3 bis 11, **dadurch gekennzeichnet, dass** senkrecht zu den totalreflektierenden Grenzflächen (6) Spiegel (10) angeordnet sind, die an diesen Grenzflächen (6) reflektiertes Licht auf das energiewandelnde Element (9) lenken.

13. Vorrichtung nach einem der Ansprüche 11 bis 12, **dadurch gekennzeichnet, dass** die Spiegel (10) jeweils an den Flächen der Vorrichtung angeordnet sind, die keine totalreflektierenden Grenzflächen (6) sind und an denen kein energiewandelndes Element (9) angeordnet ist.

14. Vorrichtung nach einem der Ansprüche 3 bis 12, **dadurch gekennzeichnet, dass** die Anordnung, die Träger (3) und in Zwischenräumen zwischen den Trägern (3) transparente Festkörper (7) aufweist, von zumindest einem Spiegel (10) umfasst ist, der in einem Winkel von 60° bis 90° zu totalreflektierenden Grenzflächen (6) der transparenten Festkörper (7) angeordnet ist.

15. Vorrichtung nach einem der voranstehenden Ansprüche, **dadurch gekennzeichnet, dass** zumindest zwei Träger (3) sich jeweils nur über einen Anteil des Abstands zwischen den totalreflektierenden Grenzflächen (6) erstrecken und voneinander mit Versatz entlang einer der totalreflektierenden Grenzflächen (6) angeordnet sind.

16. Vorrichtung nach einem der voranstehenden Ansprüche, **dadurch gekennzeichnet, dass** die Träger (3) stabförmig und in Ausnehmungen eines einstückigen transparenten Festkörpers (7) angeordnet sind, oder dass die Träger (3) flächig sind und in Ausnehmungen eines transparenten Festkörpers (7) angeordnet sind.

17. Vorrichtung nach einem der voranstehenden Ansprüche, **dadurch gekennzeichnet, dass** der erste Farbstoff (1) aus isotropen Molekülen besteht.

18. Vorrichtung nach einem der voranstehenden Ansprüche, **dadurch gekennzeichnet, dass** das energiewandelnde Element (9) ein photovoltaisches Element ist.

19. Verfahren zum Sammeln von Licht mittels einer Vorrichtung nach einem der voranstehenden Ansprüche, durch Absorbieren des Lichts mittels eines ersten Farbstoffs (1, 1'), der den ersten Absorptionswellenlängenbereich (11) aufweist und in einem transparenten Träger (3) verteilt ist, wobei zumindest ein Teil der vom ersten Farbstoff (1, 1') absorbierten Lichtenergie auf den zweiten Farbstoff (2) übertragen wird, der den zweiten Emissionswellenlängenbereich (14) aufweist und in dem Träger (3) verteilt ist, wobei die Moleküle des zweiten Farbstoffs (2) dieselbe räumliche Ausrichtung aufweisen und parallel zu einer gemeinsamen Ebene emittieren und das von dem zweiten Farbstoff (2) emittierte Licht auf zumindest ein photovoltaisches Element (9) fällt.

20. Verfahren nach Anspruch 19, bei dem das vom zweiten Farbstoff (2) emittierte Licht mittels totalreflektierender Grenzflächen (6) von transparenten Festkörpern (7), die zwischen den Trägern (3) angeordnet sind, und/oder mittels Spiegeln (10) auf zumindest ein energiewandelndes Element (9) gelenkt wird.

21. Verfahren nach Anspruch 19 oder 20, **dadurch gekennzeichnet, dass** der erste Farbstoff (1) einen ersten Emissionswellenlängenbereich (12) aufweist und das vom ersten Farbstoff (1, 1') emittierte Licht durch einen zweiten Farbstoff (2) absorbiert wird, der einen zweiten Absorptionswellenbereich (13), wobei sich der erste Emissionswellenlängenbereich (12) und der zweite Absorptionswellenlängenbereich (13) zumindest anteilig überdecken.

22. Verfahren nach einem der Ansprüche 19 bis 21, **dadurch gekennzeichnet, dass** Licht mittels zumindest eines dritten Farbstoffs (1b), der einen dritten Absorptionswellenlängenbereich und in einem transparenten Träger (3) verteilt ist, absorbiert wird, wobei der dritte Absorptionswellenlängenbereich sich zu maximal 20 % mit dem ersten Absorptionswellenlängenbereich (11) des ersten Farbstoffs (1) überdeckt, und dass vom dritten Farbstoff (1b) absorbierte Lichtenergie auf einen zweiten Farbstoff (2) übertragen wird, der einen zweiten Emissionswellenlängenbereich (14) aufweist und in dem Träger (3) verteilt ist, und dadurch, dass die Moleküle des zweiten Farbstoffs (2) dieselbe räumliche Ausrichtung aufweisen und parallel zu einer gemeinsamen Ebene emittieren.

23. Verfahren nach Anspruch 22, **dadurch gekennzeichnet, dass** der dritte Farbstoff (1b) in demselben Träger (3) wie der erste (1, 1') und zweite Farbstoff (2) verteilt ist oder in einem zweiten transparenten Träger (3) verteilt ist, in dem ein zweiter Farbstoff (2), der einen zweiten Emissionswellenlängenbereich (14) aufweist und in dem Träger (3) verteilt ist, und dadurch, dass die Moleküle des zweiten Farbstoffs (2) jeweils dieselbe räumliche Ausrichtung aufweisen und parallel zu einer gemeinsamen Ebene emittieren.

24. Verfahren nach einem der Ansprüche 19 bis 23, **dadurch gekennzeichnet, dass** der zumindest eine dritte Farbstoff (1b) einen dritten Emissionswellenlängenbereich aufweist und dass das vom dritten Farbstoff (1b) emittierte Licht durch den zweiten Farbstoff (2), der einen zweiten Absorptionswellenbereich (13) aufweist, absorbiert wird, wobei sich der dritte Emissionswellenlängenbereich und der zweite Absorptionswellenlängenbereich (14) zumindest anteilig überlappen.

25. Verfahren nach einem der Ansprüche 19 bis 24, **dadurch gekennzeichnet, dass** direktes Licht durch ein optisches Element (5) kollimiert und direkt auf das zumindest eine energiewandelnde Element (9) geleitet wird und diffus gestreutes Licht durch das optische Element tritt und auf den Träger (3) trifft.

26. Verfahren zur Herstellung einer Vorrichtung nach einem der Ansprüche 1 bis 18, **dadurch gekennzeichnet, dass** ein transparenter Träger (3), in dem ein erster Farbstoff (1, 1') verteilt ist, der einen ersten Absorptionswellenlängenbereich (11) aufweist und der isotrop ist, und ein zweiter Farbstoff (2) verteilt ist, der einen zweiten Emissionswellenlängenbereich (14) aufweist, so dass der zweite Farbstoff (2) eine Molekülform aufweist, die bei Recken des Trägers (1b) ausgerichtet wird, und die Moleküle des zweiten Farbstoffs (2) jeweils dieselbe räumliche Ausrichtung aufweisen, durch Einbringen des ersten Farbstoffs (1, 1') und des zweiten Farbstoffs (2) in das Material eines transparenten Trägers (3) und Recken des Trägers (3) in zumindest 1 Richtung hergestellt wird.

27. Verfahren nach Anspruch 26, **dadurch gekennzeichnet, dass** der Träger (3) eine Kunststofffolie ist.

28. Verfahren nach einem der Ansprüche 26 bis 27, **dadurch gekennzeichnet, dass** der erste Farbstoff (1) anisotrop ist.

29. Verfahren nach einem der Ansprüche 26 bis 28, **dadurch gekennzeichnet, dass** der erste Farbstoff (1) und/oder der zweite Farbstoff (2) Nanopartikel sind.

## Claims

1. Device for guiding light, comprising a transparent support (3) in which there is distributed a first dye (1, 1') having a first absorption wavelength region (11) and a first emission wavelength region (12), and a second dye (2) which is composed of anisotropic molecules and which has a second absorption wavelength region (13) and a second emission wavelength region (14), the transition dipole moments of the second dye (2) having a spatial orientation in which they are arranged at an angle of at most 30° to one another and parallel to the plane in which the transition dipole moments of the second dye (2) are aligned, an energy-converting element (9) is arranged, **characterized in that** the first dye (1, 1') is contained in the carrier (3) in randomly distributed alignment and the first emission wavelength region (12) and the second absorption wavelength region (13) overlap at least in part or **in that** the molecules of the first dye (1, 1') in the carrier (3) have the same spatial orientation in which they are arranged at an angle of at most 30° to one another and the first emission wavelength region (12) and the second absorption wavelength region (13) overlap at least in part.

2. Device according to claim 1, **characterized in that** the molecules of the first dye (1, 1') in the carrier (3) have the same spatial orientation in which they are arranged at an angle of at most 20°, at most 10° or at most 2° to one another.

3. Device according to one of the preceding claims, **characterized in that** between at least two supports (3) a transparent solid body (7) is arranged, the end faces of which, which are not parallel to the supports (3), form totally reflecting interfaces (6), which are arranged to direct the emitted light of the second emission wavelength range (14) to the energy-converting element (9).

4. Device according to claim 3, **characterized in that** in the support (3) the first dye (1, 1') is aligned with its transition dipole moments parallel to the total reflective interface (6).

5. Device according to any one of claims 3 to 4, **characterized in that** at an angle to the plane in which the transition dipole moments of the molecules of the second dye (2) are arranged, the at least one total reflective interface (6) is arranged to direct emitted light of the second emission wavelength range (14) to a photovoltaic element (9).

6. Device according to any one of the preceding claims, **characterized by** an optical element (5) arranged to direct collimated direct light directly onto at least one energy converting element (9) and to direct or cause diffusely scattered light to impinge on a carrier (3).

7. Device according to one of the preceding claims, **characterized by** at least one third dye (1b), which in each case has a third absorption wavelength range and is distributed in a transparent carrier (3), the respective third absorption wavelength range overlapping to a maximum of 10% with the first absorption wavelength range (11) of the first dye (1), and the second dye (2), the molecules of which in each case have the same spatial orientation, being distributed in the carrier (3).

8. Device according to claim 7, **characterized in that** said third dye (1b) is dispersed in the same carrier (3) as said first (1, 1') and second dye (2), or is dispersed in a second transparent carrier (3), in which carrier (3) a second dye (2) having a second emission wavelength range (14) is dispersed in said carrier (3), and **in that** the molecules of said second dye (2) each have the same spatial orientation and emit in a common plane.

9. Device according to any one of claims 7 to 8, **characterized in that** the at least one third dye (1b) respectively has a third emission wavelength region and the second dye (2) has a second absorption wavelength region (13), and the respective third emission wavelength region and the second absorption wavelength region (14) overlap at least in part.

10. Device according to any one of the preceding claims, **characterized in that** the first dye (1) and/or the second dye (2) are nanoparticles.

11. Device according to one of the preceding claims, **characterized in that** at least two carriers (3) are arranged in parallel and that mirrors (10) are arranged which direct the emitted light of the second emission wavelength range (14) to an energy-converting element (9).

12. Device according to any one of claims 3 to 11, **characterized in that** mirrors (10) are arranged in perpendicular to the totally reflecting interfaces (6), which mirrors (10) direct light reflected at these interfaces (6) onto the energy-converting element (9).

13. Device according to any one of claims 11 to 12, **characterized in that** the mirrors (10) are respectively arranged on the surfaces of the device which are not totally reflecting interfaces (6) and on which no energy-converting element (9) is arranged.

14. Device according to any one of claims 3 to 12, **characterized in that** the arrangement comprising supports (3) and, in interstices between the supports (3), transparent solids (7) is comprised of at least one mirror (10) arranged at an angle of 60° to 90° to totally reflecting interfaces (6) of the transparent solids (7).

15. Device according to one of the preceding claims, **characterized in that** at least two carriers (3) each extend only over a portion of the distance between the totally reflecting interfaces (6) and are arranged with an offset from each other along one of the totally reflecting interfaces (6).

16. Device according to one of the preceding claims, **characterized in that** the supports (3) are rod-shaped and are arranged in recesses of a one-piece transparent solid body (7), or **in that** the supports (3) are planar and are arranged in recesses of a transparent solid body (7).

17. Device according to one of the preceding claims, **characterized in that** the first dye (1) consists of isotropic molecules.

18. Apparatus according to any one of the preceding claims, **characterized in that** the energy converting element (9) is a photovoltaic element.

19. Process of collecting light by means of a device according to any one of the preceding claims, by absorbing said light by means of a first dye (1, 1') having the first absorption wavelength range (11) and distributed in a transparent support (3), at least part of the light energy absorbed by the first dye (1, 1') being transferred to the second dye (2) having the second emission wavelength range (14) and being distributed in the support (3), the molecules of the second dye (2) having the same spatial orientation and emitting parallel to a common plane, the light emitted by the second dye (2) being incident on at least one photovoltaic element (9).

20. Process according to claim 19, wherein the light emitted by the second dye (2) is directed to at least one energy-converting element (9) by means of totally reflecting interfaces (6) of transparent solids (7) arranged between the supports (3) and/or by means of mirrors (10).

21. Process according to claim 19 or 20, **characterized in that** the first dye (1) has a first emission wavelength region (12) and the light emitted by the first dye (1, 1') is absorbed by a second dye (2) having a second absorption wavelength region (13), the first emission wavelength region (12) and the second absorption wavelength region (13) overlapping at least in part.

22. Process according to any one of claims 19 to 21, **characterized in that** light is absorbed by means of at least a third dye (1b) having a third absorption wavelength region and being dispersed in a transparent carrier (3), said third absorption wavelength region overlapping to a maximum of 20% with the first absorption wavelength region (11) of said first dye (1), and **in that** light energy absorbed by the third dye (1b) is transferred to a second dye (2) having a second emission wavelength region (14) and is distributed in the support (3), and **in that** the molecules of the second dye (2) have the same spatial orientation and emit in parallel to a common plane.

23. Process according to claim 22, **characterized in that** said third dye (1b) is dispersed in the same carrier (3) as said first (1, 1') and second dye (2) or is dispersed in a second transparent carrier (3) in which a second dye (2) having a second emission wavelength region (14) and being dispersed in said carrier (3), and **in that** the molecules of said second dye (2) each have the same spatial orientation and emit parallel to a common plane.

24. Process according to any one of claims 19 to 23, **characterized in that** the at least one third dye (1b) has a third emission wavelength region and that the light emitted from the third dye (1b) is transmitted through the second dye (2) having a second absorption wavelength region (13), is absorbed, the third emission wavelength range and the second absorption wavelength range (14) overlapping at least in part.

25. Process according to any one of claims 19 to 24, **characterized in that** direct light is collimated by an optical element (5) and directed directly onto the at least one energy converting element (9) and diffusely scattered light passes through the optical element and impinges on the support (3).

26. Process of manufacturing a device according to any one of claims 1 to 18, **characterized in that** a transparent support (3) in which a first dye (1, 1') is distributed and has a first absorption wavelength region (11) and which is isotropic, and a second dye (2) having a second emission wavelength region (14) is distributed such that the second dye (2) has a molecular shape which is aligned upon stretching of the support (1b), and the molecules of the second dye (2) each have the same spatial alignment, is produced by introducing the first dye (1, 1') and the second dye (2) into the material of a transparent support (3) and stretching the support (3) in at least 1 direction.

27. Process according to claim 26, **characterized in that** the carrier (3) is a plastic film.

28. Process according to any one of claims 26 to 27, **characterized in that** the first dye (1) is anisotropic.

29. Process according to any one of claims 26 to 28, **characterized in that** the first dye (1) and/or the second dye (2) are nanoparticles.

## Revendications

1. Dispositif de guidage de lumière comprenant un support transparent (3) dans lequel est dispersé un premier colorant (1, 1') ayant une première gamme de longueurs d'onde d'absorption (11) et une première gamme de longueurs d'onde d'émission (12), et un second colorant (2) est dispersé, qui est constitué de molécules anisotropes et qui présente une deuxième gamme de longueurs d'onde d'absorption (13) et une deuxième gamme de longueurs d'onde d'émission (14), les moments dipolaires de transition du deuxième colorant (2) présentant une orientation spatiale dans laquelle ils sont disposés selon un angle de 30° maximum les uns par rapport aux autres, et parallèlement au plan, dans lequel les moments dipolaires de transition du deuxième colorant (2) sont orientés, un élément de conversion d'énergie (9) est disposé, **caractérisé en ce que** le premier colorant (1, 1') est contenu dans le support (3) selon une orientation répartie de manière aléatoire et **en ce que** la première gamme de longueurs d'onde d'émission (12) et la deuxième gamme de longueurs d'onde d'absorption (13) se chevauchent au moins proportionnellement, ou **en ce que** les molécules du premier colorant (1, 1') présentent dans le support (3) la même orientation spatiale, dans laquelle elles sont disposées les unes par rapport aux autres selon un angle de 30° maximum, et la première gamme de longueurs d'onde d'émission (12) et la deuxième gamme de longueurs d'onde d'absorption (13) se chevauchent au moins proportionnellement.

2. Dispositif selon la revendication 1, **caractérisé en ce que** les molécules du premier colorant (1, 1') dans le support (3) ont la même orientation spatiale, dans laquelle elles sont disposées les unes par rapport aux autres selon un angle de 20° maximum, de 10° maximum ou de 2° maximum.

3. Dispositif selon l'une des revendications précédentes, **caractérisé en ce qu'**entre au moins deux supports (3) est disposé un corps solide transparent (7) dont les faces frontales, qui ne sont pas parallèles aux supports (3), forment des interfaces à réflexion totale (6) qui sont adaptées pour diriger la lumière émise de la deuxième gamme de longueurs d'onde d'émission (14) vers l'élément de conversion d'énergie (9).

4. Dispositif selon la revendication 3, **caractérisé en ce que**, dans le support (3), le premier colorant (1, 1') est orienté avec ses moments dipolaires de transition parallèlement à l'interface à réflexion totale (6).

5. Dispositif selon l'une quelconque des revendications 3 à 4, **caractérisé en ce que**, à un angle par rapport au plan dans lequel les moments dipolaires de transition des molécules du deuxième colorant (2) sont situés, ladite au moins une interface à réflexion totale (6) est disposée pour diriger la lumière émise de la deuxième gamme de longueurs d'onde d'émission (14) vers un élément photovoltaïque (9).

6. Dispositif selon l'une quelconque des revendications précédentes, **caractérisé par** un élément optique (5) agencé pour diriger une lumière directe collimatée directement sur au moins un élément de conversion d'énergie (9) et pour diriger ou faire frapper une lumière diffusée sur un support (3).

7. Dispositif selon l'une des revendications précédentes, **caractérisé par** au moins un troisième colorant (1b) qui présente respectivement une troisième gamme de longueurs d'onde d'absorption et qui est réparti dans un support transparent (3), la troisième gamme de longueurs d'onde d'absorption respective se recouvrant au maximum à 10 % avec la première gamme de longueurs d'onde d'absorption (11) du premier colorant (1) et le deuxième colorant (2) dont les molécules présentent respectivement la même orientation spatiale étant réparti dans le support (3).

8. Dispositif selon la revendication 7, **caractérisé en ce que** le troisième colorant (1b) est réparti dans le même support (3) que le premier (1, 1') et le deuxième colorant (2) ou est réparti dans un deuxième support transparent (3), dans lequel support (3) un deuxième colorant (2) ayant une deuxième gamme de longueurs d'onde d'émission (14) est réparti dans le support (3), et **en ce que** les molécules du deuxième colorant (2) ont chacune la même orientation spatiale et émettent dans un plan commun.

9. Dispositif selon l'une des revendications 7 à 8, **caractérisé en ce que** le au moins un troisième colorant (1b) a respectivement une troisième gamme de longueurs d'onde d'émission et le deuxième colorant (2) a une deuxième gamme de longueurs d'onde d'absorption (13) et la troisième gamme de longueurs d'onde d'émission respective et la deuxième gamme de longueurs d'onde d'absorption (14) se recouvrent au moins en partie.

10. Dispositif selon l'une des revendications précédentes, **caractérisé en ce que** le premier colorant (1) et/ou le deuxième colorant (2) sont des nanoparticules.

11. Dispositif selon l'une des revendications précédentes, **caractérisé en ce qu'**au moins deux supports (3) sont disposés en parallèle et **en ce que** des miroirs (10) sont disposés pour diriger la lumière émise de la deuxième gamme de longueurs d'onde d'émission (14) vers un élément de conversion d'énergie (9).

12. Dispositif selon l'une des revendications 3 à 11, **caractérisé en ce que** des miroirs (10) sont disposés perpendiculairement aux interfaces (6) à réflexion totale et dirigent la lumière réfléchie par ces interfaces (6) vers l'élément (9) à conversion d'énergie.

13. Dispositif selon l'une des revendications 11 à 12, **caractérisé en ce que** les miroirs (10) sont respectivement disposés sur les surfaces du dispositif qui ne sont pas des interfaces (6) à réflexion totale et sur lesquelles aucun élément (9) de conversion d'énergie n'est disposé.

14. Dispositif selon l'une quelconque des revendications 3 à 12, **caractérisé en ce que** l'ensemble comprenant des supports (3) et, dans des espaces entre les supports (3), des corps solides transparents (7), est constitué d'au moins un miroir (10) disposé à un angle de 60° à 90° par rapport à des interfaces (6) de réflexion totale des corps solides transparents (7).

15. Dispositif selon l'une quelconque des revendications précédentes, **caractérisé en ce qu'**au moins deux supports (3) s'étendent chacun seulement sur une partie de la distance entre les interfaces à réflexion totale (6) et sont disposés avec un décalage l'un par rapport à l'autre le long de l'une des interfaces à réflexion totale (6).

16. Dispositif selon l'une des revendications précédentes, **caractérisé en ce que** les supports (3) sont en forme de tige et sont disposés dans des évidements d'un corps solide transparent (7) d'une seule pièce, ou **en ce que** les supports (3) sont plats et sont disposés dans des évidements d'un corps solide transparent (7).

17. Dispositif selon l'une des revendications précédentes, **caractérisé en ce que** le premier colorant (1) est constitué de molécules isotropes.

18. Dispositif selon l'une quelconque des revendications précédentes, **caractérisé en ce que** l'élément de conversion d'énergie (9) est un élément photovoltaïque.

19. Procédé de collecte de lumière au moyen d'un dispositif selon l'une des revendications précédentes, par absorption de la lumière au moyen d'un premier colorant (1, 1') présentant la première gamme de longueurs d'onde d'absorption (11) et réparti dans un support transparent (3), au moins une partie de l'énergie lumineuse absorbée par le premier colorant (1, 1') étant transférée au second colorant (2), qui présente la deuxième gamme de longueurs d'onde d'émission (14) et est réparti dans le support (3), les molécules du deuxième colorant (2) ayant la même orientation spatiale et émettant parallèlement à un plan commun, la lumière émise par le deuxième colorant (2) étant incidente sur au moins un élément photovoltaïque (9).

20. Procédé selon la revendication 19, dans lequel la lumière émise par le deuxième colorant (2) est dirigée sur au moins un élément de conversion d'énergie (9) au moyen d'interfaces à réflexion totale (6) de corps solides transparents (7) qui sont disposés entre les supports (3) et/ou au moyen de miroirs (10).

21. Procédé selon la revendication 19 ou 20, **caractérisé en ce que** le premier colorant (1) présente une première gamme de longueurs d'onde d'émission (12) et la lumière émise par le premier colorant (1, 1') est absorbée par un deuxième colorant (2) qui présente une deuxième gamme de longueurs d'onde d'absorption (13), la première gamme de longueurs d'onde d'émission (12) et la deuxième gamme de longueurs d'onde d'absorption (13) se recouvrant au moins en partie.

22. Procédé selon l'une quelconque des revendications 19 à 21, **caractérisé en ce que** la lumière est absorbée au moyen d'au moins un troisième colorant (1b) ayant une troisième gamme de longueurs d'onde d'absorption et réparti dans un support transparent (3), ladite troisième gamme de longueurs d'onde d'absorption recouvrant au maximum 20 % de la première gamme de longueurs d'onde d'absorption (11) du premier colorant (1), et **en ce que** l'énergie lumineuse absorbée par le troisième colorant (1b) est transférée à un deuxième colorant (2) qui présente une deuxième gamme de longueurs d'onde d'émission (14) et qui est réparti dans le support (3), et **en ce que** les molécules du deuxième colorant (2) présentent la même orientation spatiale et émettent parallèlement à un plan commun.

23. Procédé selon la revendication 22, **caractérisé en ce que** le troisième colorant (1b) est réparti dans le même support (3) que le premier (1, 1') et le deuxième colorant (2) ou est réparti dans un deuxième support transparent (3) dans lequel un deuxième colorant (2) ayant une deuxième gamme de longueurs d'onde d'émission (14) et est réparti dans le support (3), et **en ce que** les molécules du deuxième colorant (2) ont chacune la même orientation spatiale et émettent parallèlement à un plan commun.

24. Procédé selon l'une quelconque des revendications 19 à 23, **caractérisé en ce que** ledit au moins un troisième colorant (1b) présente une troisième gamme de longueurs d'onde d'émission et **en ce que** la lumière émise par le troisième colorant (1b) est transmise par le deuxième colorant (2) qui présente une deuxième gamme d'onde d'absorption (13), la troisième gamme de longueurs d'onde d'émission et la deuxième gamme de longueurs d'onde d'absorption (14) se chevauchant au moins en partie.

25. Procédé selon l'une quelconque des revendications 19 à 24, **caractérisé en ce que** la lumière directe est collimatée par un élément optique (5) et dirigée directement sur ledit au moins un élément de conversion d'énergie (9), et la lumière diffusée traverse l'élément optique et frappe le support (3).

26. Procédé de fabrication d'un dispositif selon l'une des revendications 1 à 18, **caractérisé en ce qu'**il comprend un support transparent (3) dans lequel sont répartis un premier colorant (1, 1') présentant une première gamme de longueurs d'onde d'absorption (11) et qui est isotrope, et un deuxième colorant (2) présentant une deuxième gamme de longueurs d'onde d'émission (14), de sorte que le deuxième colorant (2) a une forme moléculaire qui est orientée lorsque le support (1b) est étiré, et les molécules du deuxième colorant (2) ont chacune la même orientation spatiale, est produite en introduisant le premier colorant (1, 1') et le deuxième colorant (2) dans le matériau d'un support transparent (3) et en étirant le support (3) dans au moins 1 direction.

27. Procédé selon la revendication 26, **caractérisé en ce que** le support (3) est un film plastique.

28. Procédé selon l'une quelconque des revendications 26 à 27, **caractérisé en ce que** le premier colorant (1) est anisotrope.

29. Procédé selon l'une quelconque des revendications 26 à 28, **caractérisé en ce que** le premier colorant (1) et/ou le deuxième colorant (2) sont des nanoparticules.
